# EUROPEAN PATENT APPLICATION

(11) **EP 2 757 122 A2**
(43) Date of publication of application: **23.07.2014**
(21) Application number: 14001379.8
(22) Date of filing: 06.12.2010
(51) Int. Cl.: C08G 18/81, C08G 18/83, C08F 290/06, C09D 5/25, C09D 175/16, H05K 3/28

(54) **Photocurable moisture-proof insulating coating material for mounting circuit boards**

(30) Priority: 14.12.2009 JP 2009283328
(62) Divisional of application: 10837530.4
(71) Applicant: Showa Denko K.K., Tokyo 105-8518 (JP)
(72) Inventor: Ooga, Kazuhiko, Tokyo 105-8518 (JP); Azuma, Ritsuko, Tokyo 105-8518 (JP)
(74) Representative: Strehl Schübel-Hopf & Partner

(57) **Abstract**

The present invention provides a photocurable moistureproof insulating coating material for mounting circuit boards, comprising a curable composition comprising:
(component A) a compound having a structural unit derived from a dimerdiol and having, as an end group, a group represented by formula (1): 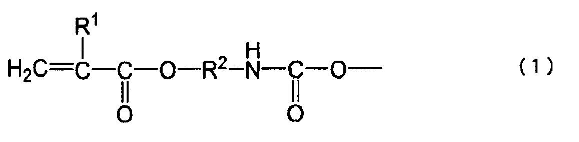 wherein R¹ represents H or CH₃ and R² represents a hydrocarbon group having 2 to 12 carbon atoms, at an end of the compound;
(component B) a non-silicon-containing monofunctional (meth)acryloyl group-containing compound; and
(component C) a photopolymerization initiator.

## Description

### TECHNICAL FIELD

The present invention relates to a novel polymerizable compound, a curable composition comprising the polymerizable compound as an essential component, a photocurable moisture-proof insulating coating material for mounting circuit boards, which contains the curable composition, and an electronic component insulated with the photocurable moisture-proof insulating coating material.

### BACKGROUND ART

There are known carboxyl group-containing polyurethanes having a structural unit derived from a dimerdiol (for example, JP 2000-7909 A, JP 2007-100037 A, JP 10-273514 A, and JP 10-251369 A).

However, none of the Patent Literature has reported any radical polymerizable compound having a structural unit derived from a dimerdiol.

JP 2007-314768 A discloses a urethane methacrylate compound prepared by using, as a raw material, a (meth)acryloyl group-containing compound having an isocyanate group. In addition, JP 2005-331932 A discloses a urethane acrylate compound prepared by using an acryloyl group-containing compound having an isocyanate group and a polyol compound, as raw materials.

The Patent Literatures above do not report any compound having a structural unit derived from a dimerdiol nor any compound having a structural unit derived from a hydrogenated dimerdiol.

On the other hand, electric apparatuses are becoming smaller, lighter, and more multifunctional year by year, and, to protect the apparatuses from moisture, dust, gas, and the like, mounting circuit boards incorporated in the various apparatuses for control thereof are insulated. As an insulation treatment method, protection coating treatment using a coating material such as an acryl-based resin or urethane-based resin is widely employed. In general, such a moisture-proof insulating coating material is dissolved in an organic solvent to be applied and then dried, thereby forming an intended coating film.

These moisture-proof insulating coating materials, however, cause air pollution due to the exhaustion of organic solvents in the air during coating. In addition, the organic solvents have a high risk of causing a fire, and therefore the moisture-proof insulating coating materials pose serious environmental impact.

In addition, many kinds of resin compositions curable by UV or electron beam irradiation have been developed and a variety of photocurable coating materials have already been practically applied and utilized for insulating mounting circuit boards. As such resin compositions, there are known urethane-modified acrylate resin compositions prepared by the reaction of a polyester polyol compound, polyolefin polyol compound or the like with polyisocyanate and hydroxyalkyl (meth)acrylate.

In addition, JP 2001-302946 A discloses a photocurable moisture-proof insulating coating material comprising an acrylic-modified hydrogenated polybutadiene resin highly adhesive to glass and also exhibiting excellent properties in moisture resistance evaluation.

Furthermore, JP 2008-291114 A discloses a photocurable moisture-proof insulating coating material comprising a reaction mixture obtained by the reaction of 2-hydroxyethyl acrylate, hydrogenated polybutadienediol and tolylenediisocyanate in such a manner that the mixing ratio of hydroxy group to isocyanate group is larger than 1, isobornyl acrylate, lauryl acrylate, and an alkoxysilane compound having an isocyanate group, with a photopolymerization initiator.

Furthermore, JP 2008-303362 A discloses a photocurable moisture-proof insulating coating material comprising a reaction mixture obtained by the reaction of 2-hydroxyethyl acrylate, hydrogenated polybutadienediol, and tolylenediisocyanate, lauryl acrylate, bisphenol A propylene glycol adduct diacrylate, and an alkoxysilane compound having an isocyanate group.

However, the urethane-modified acrylate resin compositions using polyester polyol compounds generally have high moisture permeability, and the urethane-modified acrylate resins using polyolefin polyol compounds have low adhesion to substrate materials. Therefore, coating materials comprising these photocurable resin compositions have had a similar problem in terms of reliability of electronic components when using them as moisture-proof insulating coating materials for mounting circuit boards.

Additionally, the resin composition disclosed in JP 2001-302946 A has been drawing attention, since the composition polymerizes even at high oxygen concentration level and also the physical properties of cured products are variously changed according to their structures and combinations. However, the resin composition has exhibited high viscosity at room temperature, which has been problematic in handling.

The resin compositions disclosed in JP 2008-291114 A and JP 2008-303362 A have had a problem of increased viscosity with time, although it has been relatively low at room temperature immediately after mixing.

Additionally, the urethane (meth)acrylate compounds disclosed in JP 2008-291114 A and JP 2008-303362 A have had a problem of too high viscosity, in which it has been impossible to adjust to a desired viscosity without adding a large amount of a monofunctional acrylate, such as 2-hydroxyethyl acrylate, isobornyl acrylate, or lauryl acrylate.

### PRIOR ART REFERENCES

### PATENT LITERATURE

Patent Literature 1: JP 2000-7909 A
Patent Literature 2: JP 2007-100037 A
Patent Literature 3: JP 10-273514 A
Patent Literature 4: JP 10-251369 A
Patent Literature 5: JP 2007-314768 A
Patent Literature 6: JP 2005-331932 A
Patent Literature 7: JP 2001-302946 A
Patent Literature 8: JP 2008-291114 A
Patent Literature 9: JP 2008-303362 A

### SUMMARY OF INVENTION

### TECHNICAL PROBLEMS

The present invention has been accomplished in view of the problems of the conventional techniques described above. It is an object of the present invention to provide a photocurable composition and a photocurable moisture-proof insulating coating material for mounting circuit boards, which pose less environmental impact, excel in surface curability at low irradiation dose, and have high adhesion to substrate materials.

It is another object of the present invention to provide a novel polymerizable compound suitable as a component of the photocurable composition and the photocurable moisture-proof insulating coating material.

It is a further another object of the present invention to provide a highly reliable electronic component insulated with the photocurable moisture-proof insulating coating material for mounting circuit boards.

### SOLUTION TO PROBLEM

Through intensive investigation to solve the problems, the present inventors have discovered that a photocurable composition comprising a novel polyurethane having a specific structure and having a (meth)acryloyl group is easy for handling and requires lower irradiation dose for curing than in the conventional compositions, as well as cured products obtained by curing the photocurable composition have excellent electrical insulating properties, thereby completing the present invention.

Specifically, present invention (I) relates to a compound having a structural unit derived from a dimerdiol and having, as an end group, a group represented by formula (1): 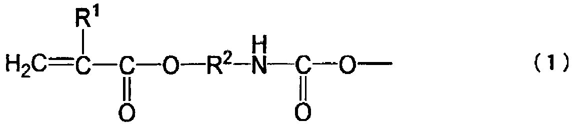 in which R¹ represents H or CH₃, and R² represents a hydrocarbon group having 2 to 12 carbon atoms, at an end of the compound.

Present invention (II) relates to a compound of present invention (I) characterized by having, as end groups, the group represented by formula (1) and a group represented by formula (2): 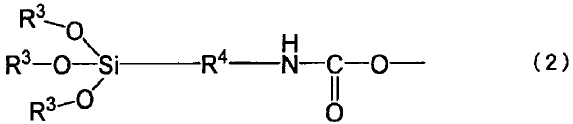 in which R³s each independently represent CH₃ or CH₂CH₃, and R⁴ represents a hydrocarbon group having 3 to 9 carbon atoms, at the end of the compound.

Present invention (III) relates to a method for producing a compound having a structural unit derived from a dimerdiol and having, as an end group, a group represented by formula (1): 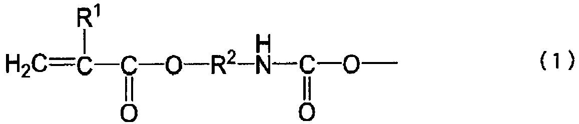 wherein R¹ represents H or CH₃ and R² represents a hydrocarbon group having 2 to 12 carbon atoms, at an end of the compound, wherein the method comprises conducting addition polymerization reaction using, as raw materials,
(a1) a dimerdiol;
(a2) a polyisocyanate compound comprising a diisocyanate compound; and
(a3) a compound represented by formula (5): 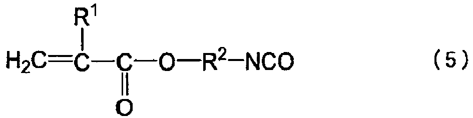 wherein R¹ represents H or CH₃ and R² represents a hydrocarbon group having 2 to 12 carbon atoms.

Present invention (IV) relates to a method for producing a compound having a structural unit derived from a dimerdiol and having, as end groups, a group represented by formula (1): 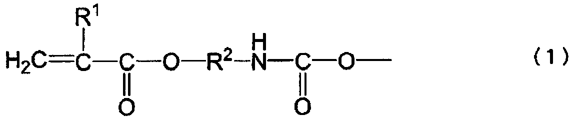 wherein R¹ represents H or CH₃ and R² represents 2 to 12 carbon atoms, and a group represented by formula (2): 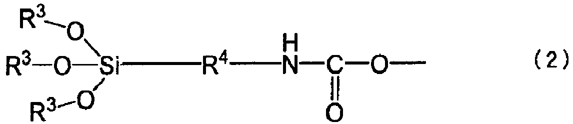 wherein R³s each independently represent CH₃ or CH₂CH₃ and R⁴ represents a hydrocarbon group having 3 to 9 carbon atoms, at an end of the compound, wherein the method comprises conducting addition polymerization reaction using, as raw materials,
(a1) a dimerdiol;
(a2) a polyisocyanate compound comprising a diisocyanate compound;
(a3) a compound represented by formula (5): 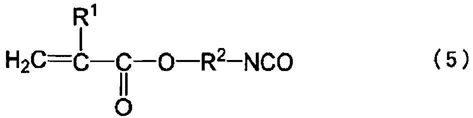 wherein R¹ represents H or CH₃ and R² represents a hydrocarbon group having 2 to 12 carbon atoms; and
(a4) a compound represented by formula (6): 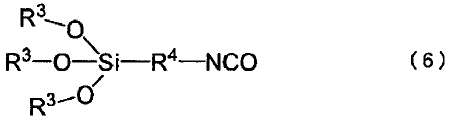 wherein R³s each independently represent CH₃ or CH₂CH₃ and R⁴ represents a hydrocarbon group having 3 to 9 carbon atoms.

Present invention (V) relates to a curable composition comprising:
(component A) the compound of present invention (I) and/or the compound of present invention (II);
(component B) a non-silicon-containing monofunctional (meth)acryloyl group-containing compound; and
(component C) a photopolymerization initiator.

Present invention (VI) relates to a photocurable moisture-proof insulating coating material for mounting circuit boards, comprising the curable composition of present invention (V).

Present invention (VII) relates to an electronic component insulated with the photocurable moisture-proof insulating coating material for mounting circuit boards according to present invention (VI).

More specifically, the present invention relates to the following [1] to [15]:
[1] A compound having a structural unit derived from a dimerdiol and having, as an end group, a group represented by formula (1): 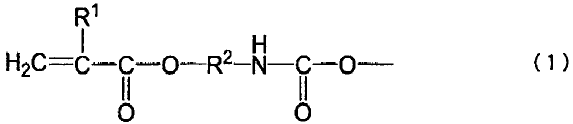 wherein R¹ represents H or CH₃ and R² represents a hydrocarbon group having 2 to 12 carbon atoms, at an end of the compound.
[2] The compound according to [1], wherein the compound has, as end groups, the group represented by the formula (1) and a group represented by formula (2): 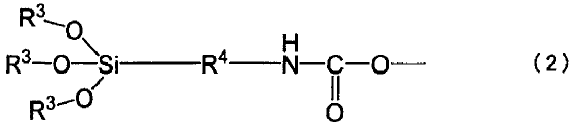 wherein R³s each independently represent CH₃ or CH₂CH₃ and R⁴ represents a hydrocarbon group having 3 to 9 carbon atoms, at the end of the compound.
[3] The compound according to [1] or [2], wherein the structure having the structural unit derived from a dimerdiol is represented by formula (3): 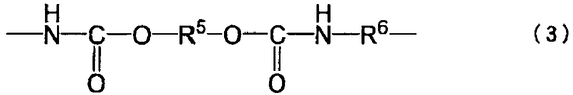 wherein R⁵ each independently represents an organic residue derived from a dimerdiol and R⁶ each independently represents one or more organic residues comprising as an essential component an organic residue derived from a polyisocyanate compound, with the proviso that R⁶ can further have a branched structure represented by formula (3) by an urethane bond.
[4] The compound according to any one of [1] to [3], represented by formula (4): 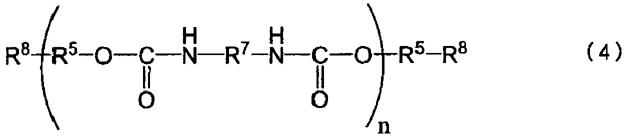 wherein n represents 0 or an integer of 1 to 20; R⁵s each independently represent an organic residue derived from a dimerdiol; R⁷ each independently represents an organic residue derived from a diisocyanate compound; and one of two R⁸s represents the group represented by formula (1), whereas the other one thereof represents the group represented by formula (1) or formula (2).
[5] The compound according to any one of [1] to [4], wherein R¹ in formula (1) is H.
[6] The compound according to any one of [1] to [5], wherein the dimerdiol comprises a compound represented by formula (7): 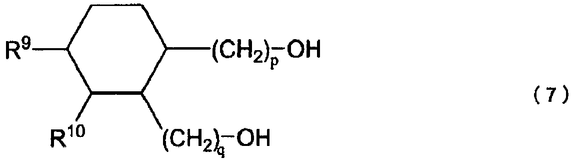 wherein R⁹ and R¹⁰ are both alkyl and a sum of the numbers of carbon atoms in R⁹ and R¹⁰ and the numbers of p and q is 30, and/or a compound represented by formula (8): 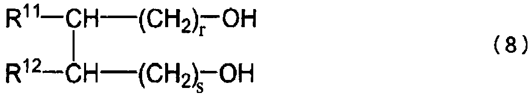 wherein R¹¹ and R¹² are both alkyl and a sum of the numbers of carbon atoms in R¹¹ and R¹² and the numbers of r and s is 34.
[7] A method for producing a compound having a structural unit derived from a dimerdiol and having, as an end group, a group represented by formula (1): 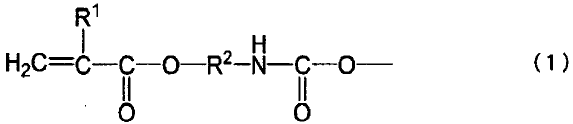 wherein R¹ represents H or CH₃ and R² represents a hydrocarbon group having 2 to 12 carbon atoms, at an end of the compound, wherein the method comprises conducting addition polymerization reaction using, as raw materials,
   (a1) a dimerdiol;
   (a2) a polyisocyanate compound comprising a diisocyanate compound; and
   (a3) a compound represented by formula (5): 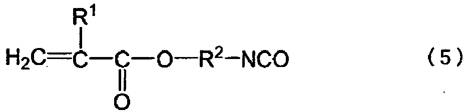 wherein R¹ represents H or CH₃ and R² represents a hydrocarbon group having 2 to 12 carbon atoms.
[8] A method for producing a compound having a structural unit derived from a dimerdiol and having, as end groups, a group represented by formula (1): 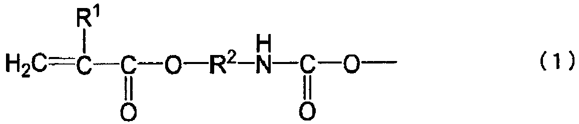 wherein R¹ represents H or CH₃ and R² represents a hydrocarbon group having 2 to 12 carbon atoms, and a group represented by formula (2): 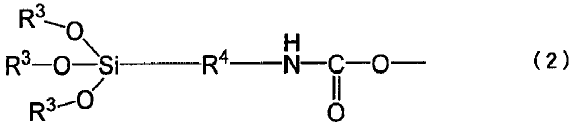 wherein R³s each independently represent CH₃ or CH₂CH₃ and R⁴ represents a hydrocarbon group having 3 to 9 carbon atoms, at an end of the compound, wherein the method comprises conducting addition polymerization reaction using, as raw materials,
   (a1) a dimerdiol;
   (a2) a polyisocyanate compound comprising a diisocyanate compound;
   (a3) a compound represented by formula (5): 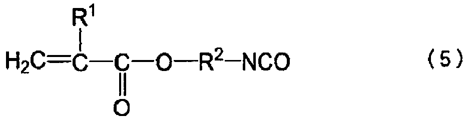 wherein R¹ represents H or CH₃ and R² represents a hydrocarbon group having 2 to 12 carbon atoms; and
   (a4) a compound represented by formula (6): 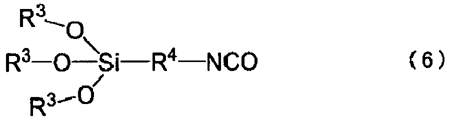
   wherein R³s each independently represent CH₃ or CH₂CH₃ and R⁴ represents a hydrocarbon group having 3 to 9 carbon atoms.
[9] The method according to [7] or [8], wherein the dimerdiol comprises a compound represented by formula (7) : 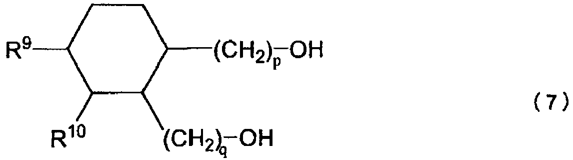 wherein R⁹ and R¹⁰ are both alkyl and the sum of the numbers of carbon atoms in R⁹ and R¹⁰ and the numbers of p and q is 30, and/or a compound represented by formula (8): 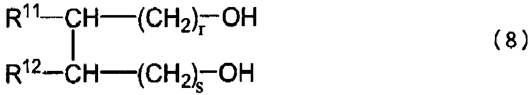 wherein R¹¹ and R¹² are both alkyl and the sum of the numbers of carbon atoms in R¹¹ and R¹² and the numbers of r and s is 34.
[10] A curable composition comprising:
   (component A) the compound according to any one of [1] to [6];
   (component B) a non-silicon-containing monofunctional (meth)acryloyl group-containing compound; and
   (component C) a photopolymerization initiator.
[11] The curable composition according to [10], further comprising (component D) a silane coupling agent.
[12] The curable composition according to [10] or [11], further comprising a non-silicon-containing compound having two or more (meth)acryloyl groups in one molecule other than component A.
[13] The curable composition according to any one of [10] to [12], wherein component B is at least one compound comprising a non-silicon-containing monofunctional (meth)acryloyl group-containing compound having a cyclic aliphatic group.
[14] A photocurable moisture-proof insulating coating material for mounting circuit boards, comprising the curable composition according to any one of [10] to [13].
[15] An electronic component insulated with the photocurable moisture-proof insulating coating material for mounting circuit boards according to [14].

### ADVANTAGEOUS EFFECTS OF INVENTION

A photocurable resin composition according to the present invention has less environmental impact and has high adhesion to substrate materials, although it is a urethane-modified acrylate resin composition having very little moisture permeability. Therefore, it is a photocurable resin composition suitable for a photocurable moisture-proof insulating coating material for mounting circuit boards. It is also advantageous in that a highly reliable electronic component can be produced by applying and curing the photocurable moisture-proof insulating coating material.

### BRIEF DESCRIPTION OF DRAWINGS

Fig. 1 shows a ¹H-NMR spectrum (solvent: CDCl₃) of urethane acrylate A obtained by Synthesis Example 1.
Fig. 2 shows an IR spectrum of urethane acrylate A obtained by Synthesis Example 1.
Fig. 3 shows a ¹H-NMR spectrum (solvent: CDCl₃) of urethane acrylate B obtained by Synthesis Example 2.
Fig. 4 shows an IR spectrum of urethane acrylate B obtained by Synthesis Example 2.
Fig. 5 shows a ¹H-NMR spectrum (solvent: CDCl₃) of urethane acrylate C obtained by Synthesis Example 3.
Fig. 6 shows an IR spectrum of urethane acrylate C obtained by Synthesis Example 3.
Fig. 7 shows a ¹H-NMR spectrum (solvent: CDCl₃) of urethane acrylate D obtained by Synthesis Example 4.
Fig. 8 shows an IR spectrum of urethane acrylate D obtained by Synthesis Example 4.
Fig. 9 shows a ¹H-NMR spectrum (solvent: CDCl₃) of urethane acrylate E obtained by Synthesis Example 5.
Fig. 10 shows an IR spectrum (solvent: CDCl₃) of urethane acrylate E obtained by Synthesis Example 5.
Fig. 11 shows a ¹H-NMR spectrum (solvent: CDCl₃) of urethane acrylate F obtained by Synthesis Example 6.
Fig. 12 shows an IR spectrum of urethane acrylate F obtained by Synthesis Example 6.

### DESCRIPTION OF EMBODIMENTS

Hereinafter, the present invention will be described in detail.

In the present specification, the term "(meth)acryloyl group" means an acryloyl group and/or a methacryloyl group.

First, present invention (I) will be described.

Present invention (I) is a compound having a structural unit derived from a dimerdiol and having, as an end group, a group represented by the following formula (1): 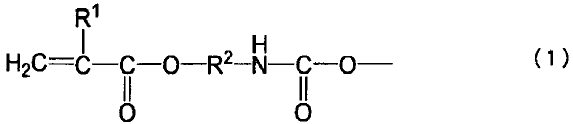 wherein R¹ represents H or CH₃ and R² represents a hydrocarbon group having 2 to 12 carbon atoms, at an end of the compound.

The expression "structural unit derived from a dimerdiol" described in the present specification means a structure obtained by removing at least one end hydroxyl group from a dimerdiol.

In general, a "dimerdiol" is composed mostly of a diol having 36 carbon atoms in which the carboxylic acid groups of a dimer acid have been converted to alcohol groups by the reduction of a dimer acid and/or lower alcohol ester thereof in the presence of a catalyst. As used herein, a dimer acid is a known dibasic acid obtained by intermolecular polymerization reaction of an unsaturated fatty acid. For example, the dimer acid is obtained by dimerization of an unsaturated fatty acid having 11 to 22 carbon atoms using a clay catalyst or the like. Industrially available dimer acid contains, besides the dibasic acid having approximately 36 carbon atoms, arbitrary amounts of trimer acid and monomer acid according to the degree of purification. As used herein, the expression "composed mostly of" means the presence of 50% or more by weight. In addition to the diol having 36 carbon atoms, a diol having 22 to 44 carbon atoms, not 36 carbon atoms, may be present. The present specification defines that the term "dimerdiol" includes not only diols composed mostly of diols having 36 carbon atoms obtained by reducing carboxylic acid groups of a dimer acid to alcohol groups, but also hydrogenated dimerdiols obtained by hydrogenation of a carbon-carbon double bond derived from a dimer acid. A particularly preferable dimerdiol in the present invention is a hydrogenated dimerdiol obtained by the hydrogenation of a dimer acid-derived carbon-carbon double bond. As examples of commercially available dimerdiol products, there may be mentioned PRIPOL^{®} 2033 and the like manufactured by Croda Inc. and Sovermol^{®} 908 manufactured by Cognis Corp.

As typical compound structures of dimerdiols, for example, there may be mentioned those represented by the following formulas (7) and (8): 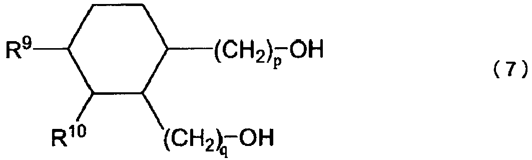 wherein R⁹ and R¹⁰ are both alkyl and a sum of the numbers of respective carbon atoms included in R⁹ and R¹⁰ and the numbers of p and q is 30; and 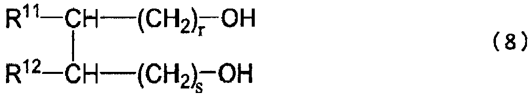 wherein R¹¹ and R¹² are both alkyl and a sum of the numbers of respective carbon atoms included in R¹¹ and R¹² and the numbers of r and s is 34.

PRIPOL^{®} 2033 is composed mostly of a mixture of the compounds represented by formulas (7) and (8).

In the compound of present invention (I), the structural unit derived from a dimerdiol is preferably a structural unit derived from a hydrogenated dimerdiol, such as PRIPOL^{®} 2033, when heat-resistant colorability is required.

In addition, the compound of present invention (I) may have, in addition to the structural unit derived from a dimerdiol, a structural unit derived from a polyol other than dimerdiols. As used herein, the expression "structural unit derived from a polyol other than dimerdiols" means a structure obtained by removing at least one end hydroxyl group from a polyol other than dimerdiols.

Examples of polyols other than dimerdiols include chain aliphatic polyols other than dimerdiols, such as 1,3-propanediol, 1,4-butanediol, 1,3-butanediol, 1,5-pentanediol, neo-pentyl glycol, 3-methyl-1,5-pentanediol, 1,6-hexanediol, 2-methyl-1,8-octanediol, 1,9-nonanediol, 2-ethyl-2-butyl-1,3-propanediol, 2,4-diethyl-1,5-pentanediol, 1,10-decanediol, and 1,12-dodecanediol; polyols having a cycloaliphatic structure other than dimerdiols, such as 1,4-cyclohexane dimethanol, 1,3-cyclohexane dimethanol, tricyclo[5.2.1.0^{2,6}]decane-dimethanol, and 2-methylcyclohexane-1,1-dimethanol; polyols having an aromatic ring, such as trimertriol, p-xylylene glycol, a bisphenol A ethylene oxide adduct, a bisphenol F ethylene oxide adduct, and a biphenol ethylene oxide adduct; polyether polyols such as polyethylene glycol, polypropylene glycol, and polytetramethylene glycol; polyester polyols such as polyhexamethylele adipate, polyhexamethylene succinate, and polycaprolactone; and (poly)carbonate diols such as α,ω-poly(1,6-hexylene carbonate) diol, α,ω-poly(3-methyl-1,5-pentylene carbonate)diol, α,ω-poly[(1,6-hexylene:3-methyl-pentamethylene)carbonate]diol, and α,ω-poly[(1,9-nonylene:2-methyl-1,8-octylene)carbonate]diol. Examples of those commercially available include PLACCEL CD-205, 205PL, 205HL, 210, 210PL, 210HL, 220, 220PL, and 220HL manufactured by Daicel Chemical Industries, Ltd., and KURARAY POLYOL C-590, C-1065N, C-1015N, and C-2015N manufactured by Kuraray Co., Ltd.

Among them, compounds preferable to maintain electrical insulation capabilities at high level and viscosity at relatively low level are chain aliphatic diols having 9 or more carbon atoms other than dimerdiols, such as 2-methyl-1,8-octanediol, 1,9-nonanediol, 2-ethyl-2-butyl-1,3-propanediol, 2,4-diethyl-1,5-pentanediol, 1,10-decanediol, and 1,12-dodecanediol; and (poly)carbonate diols having a structural unit derived from chain aliphatic polyols having 6 or more carbon atoms, such as α,ω-poly(1,6-hexylene carbonate)diol, α,ω-poly(3-methyl-1,5-pentylene carbonate)diol, α,ω-poly[(1,6-hexylene: 3-methyl-pentamethylene)carbonate]diol, and α,ω-poly[(1,9-nonylene: 2-methyl-1,8-octylene)carbonate]diol.

In the present specification, the expression "(poly)carbonate" of (poly)carbonate diol means having one or more carbonate bonds in the molecule. Accordingly, the term "(poly)carbonate diol" means a compound having one or more carbonate bonds in the molecule thereof and two alcoholic hydroxyl groups.

In formula (1), R¹ represents H or CH₃, which means that when R¹ is H, the compound of present invention (I) has an acryloyl group at a molecular end thereof, whereas when R¹ is CH₃, the compound of present invention (I) has a methacryloyl group at the molecular end thereof.

When the compound of present invention (I) has a plurality of groups represented by the formula (1) as end groups in one molecule, a plurality of R¹s in the one molecule each independently can represent either H or CH₃. Additionally, a plurality of R²s in the one molecule can also each independently represent a hydrocarbon group having 2 to 12 carbon atoms.

R¹ in the compound of present invention (I) is preferably H from the viewpoint of accelerating the curing rate of a curable composition according to present invention (V) described below.

R² in the compound of present invention (I) represents a hydrocarbon group having 2 to 12 carbon atoms. From the viewpoint of accelerating the curing rate of the curable composition of present invention (V) described below, R² in the compound of present invention (I) is preferably a hydrocarbon group having 2 to 8 carbon atoms, and more preferably a hydrocarbon group having 2 to 6 carbon atoms.

The compound of present invention (I) is preferably a compound having the group represented by formula (1) as an end group and having a group represented by the following formula (3) as a structural unit, when considering adhesion of the compound of the invention (I) to glass and indium tin oxide (hereinafter referred to as ITO).

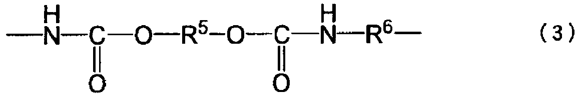

In the formula, R⁵ each independently represents an organic residue derived from a dimerdiol and R⁶ each independently represents one or more organic residues comprising as an essential component an organic residue derived from a polyisocyanate compound, with the proviso that R⁶ can further have a branched structure represented by formula (3) by a urethane bond.

In formula (3), R⁵ each independently represents an organic residue derived from a dimerdiol.

The expression "organic residue derived from a dimerdiol" described in the present specification means an organic group obtained by removing alcoholic hydroxyl groups from a dimerdiol.

The expression "R⁵ each independently" described herein means that all of portions represented by R⁵ in the structural unit represented by formula (3) in the compound of present invention (I) may have the same structure, a part of the portions may have different structures, or all of them may have different structures.

When heat-resistant colorability is required, preferably 80% or more of all the R⁵s represents an organic residue derived from a hydrogenated dimerdiol, and more preferably 90% or more thereof represents an organic residue derived from a hydrogenated dimerdiol.

R⁶ each independently represents one or more organic residues comprising an organic residue derived from a polyisocyanate compound as an essential component.

The expression "organic residue derived from a polyisocyanate compound" in the present specification means an organic residue obtained by removing all isocyanate groups from a polyisocyanate compound.

The expression "R⁶ each independently" described herein means that all of portions represented by R⁶ in the structural unit represented by formula (3) in the compound of present invention (I) may have the same structure, a part of the portions may have different structures, or all of them may have different structures.

Additionally, R⁶ can further have a branched structure represented by formula (3), which means that, for example, when R⁶ comprises an organic residue derived from 1,3,5-tris(6-isocyanatohexyl)isocyanurate, the compound of present invention (I) can have a partial structure represented by the following structural formula (9):

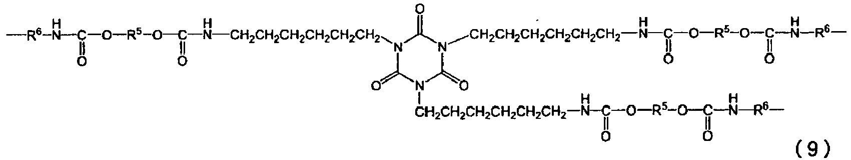

Naturally, in formula (9), a plurality of R⁵s each independently represent an organic residue derived from dimerdiol, and a plurality of R⁶ each independently represent one or more organic residues comprising as an essential component an organic residue derived from a polyisocyanate compound.

The expression "organic residue derived from 1,3,5-tris(6-isocyanatohexyl)isocyanurate" means an organic residue obtained by removing three isocyanate groups from 1,3,5-tris(6-isocyanatohexyl)isocyanurate.

However, to increase a content rate of the compound of present invention (I) in the curable composition of present invention (V) described below and maintain the viscosity thereof at low level, R⁶ in formula (3) is preferably an organic residue derived from a diisocyanate compound.

The expression "organic residue derived from a diisocyanate compound" in the present specification means an organic group obtained by removing two isocyanate groups from a diisocyanate compound.

When R⁶ in formula (3) is an organic residue derived from a diisocyanate compound, the compound of present invention (I) is represented by the following formula (10) : 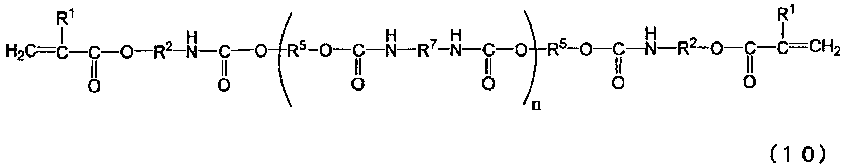 wherein n represents 0 or an integer of 1 to 20; two R¹s each independently represent H or CH₃; two R²s each independently represent a hydrocarbon group having 2 to 12 carbon atoms; R⁵ each independently represents an organic residue derived from a dimerdiol; and R⁷ each independently represents an organic residue derived from a diisocyanate compound.

The expression "two R¹s each independently" described herein means that the two R¹s in the compound represented by formula (10) may have the same structure (that is, both of the two R¹s are H or CH₃), or may have different structures (that is, one of the two R¹s is H and the other one thereof is CH₃). In formula (10), preferably, R¹ is H from the viewpoint of accelerating the curing rate of the curable composition of present invention (V) described below.

The expression "two R²s each independently" means that the two R²s in the compound represented by formula (10) may have the same structure or different structures. In formula (10), R² represents a hydrocarbon group having 2 to 12 carbon atoms. From the viewpoint of accelerating the curing rate of the curable composition of present invention (V) described below, R² in formula (10) is preferably a hydrocarbon group having 2 to 8 carbon atoms, and more preferably a hydrocarbon group having 2 to 6 carbon atoms.

The expression "R⁵ each independently" means that all of portions represented by (n + 1) pieces of R⁵s in the compound represented by formula (10) may have the same structure, a part of the portions may have different structures, or all of them may have different structures.

When heat-resistant colorability is required, preferably, 80% or more of all the R⁵s represents an organic residue derived from a hydrogenated dimerdiol, and more preferably 90% or more thereof represents an organic residue derived from a hydrogenated dimerdiol.

The expression "R⁷ each independently" means that all of portions represented by n pieces of R⁷s in the compound represented by formula (10) may have the same structure, a part of the portions may have different structures, or all of them may have different structures.

R⁷ is not restricted to any specific one as long as it is an organic residue derived from a diisocyanate compound. Specifically, examples of the organic residue include organic residues derived from 1,4-cyclohexane diisocyanate, isophorone diisocyanate, methylenebis(4-cyclohexylisocyanate), 1,3-bis(isocyanatomethyl)cyclohexane, 1,4-bis(isocyanatomethyl)cyclohexane, 2,4-tolylene diisocyanate, 2,6-tolylene diisocyanate, diphenylmethane-4,4'-diisocyanate, 1,3-xylylene diisocyanate, 1,4-xylylene diisocyanate, lysine tri-isocyanate, lysine diisocyanate, hexamethylene diisocyanate, 2,4,4-trimethylhexamethylene diisocyanate, 2,2,4-trimethylhexane methylene diisocyanate, and norbornane diisocyanate.

To maintain moisture-proof capabilities at high level, preferable organic residues are those derived from 1,4-cyclohexane diisocyanate, isophorone diisocyanate, methylenebis(4-cyclohexylisocyanate), 1,3-bis(isocyanatomethyl)cyclohexane, 1,4-bis(isocyanatomethyl)cyclohexane, diphenylmethane-4,4'-diisocyanate, 1,3-xylylene diisocyanate, 1,4-xylylene diisocyanate, 2,4,4-trimethylhexamethylene diisocyanate, 2,2,4-trimethylhexanemethylene diisocyanate, and norbornane diisocyanate, and more preferable organic residues are those derived from methylenebis(4-cyclohexylisocyanate), diphenylmethane-4,4'-diisocyanate, and norbornane diisocyanate.

Next, a description will be given of a compound according to present invention (II).

Present invention (II) is a compound having a structural unit derived from a dimerdiol and having, as end groups, the group represented by the following formula (1) and a group represented by the following formula (2) at an end of the compound: 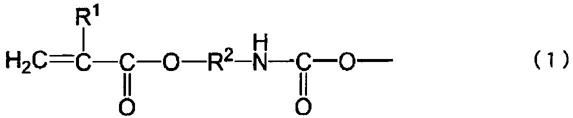 wherein R¹ represents H or CH₃, and R² represents a hydrocarbon group having 2 to 12 carbon atoms, 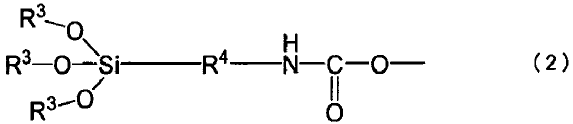 wherein R³s each independently represent CH₃ or CH₂CH₃, and R⁴ represents a hydrocarbon group having 3 to 9 carbon atoms.

Formula (1) representing one of the end groups of the compound according to present invention (II) is the same as formula (1) shown in the description of the compound according to present invention (I) above.

A description will be given of formula (2) representing one of the end groups of the compound according to present invention (II).

In formula (2), the expression "R³s each independently" means that all of the three R³s in the end group represented by formula (2) may have the same structure (i.e., all of the three R³s are CH₃ or CH₂CH₃), one of the three R³s may be CH₃ and the other two R³s may be CH₂CH₃, or two of them may be CH₃ and the remaining one may be CH₂CH₃.

In formula (2), R⁴ represents a hydrocarbon group having 3 to 9 carbon atoms. Specifically, for example, there can be mentioned structures of the following formulas (11) to (18):

-CH₂CH₂CH₂- (11)

-CH₂CH₂CH₂CH₂₋ (12)

-CH₂CH₂CH₂CH₂CH₂₋ (13)

-CH₂CH₂CH₂CH₂CH₂CH₂₋ (14)

-CH₂CH₂CH₂CH₂CH₂CH₂CH₂- (15)

-CH₂CH₂CH₂CH₂CH₂CH₂CH₂CH₂- (16)

-CH₂CH₂CH₂CH₂CH₂CH₂CH₂CH₂CH₂- (17)

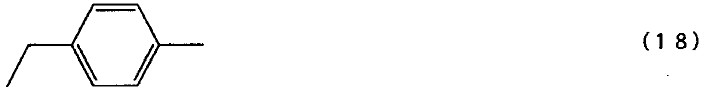

In the definition of the compound of present invention (II), the expression "structural unit derived from a dimerdiol" has the same meaning as that in the description of the compound of present invention (I) above.

The compound of present invention (II) may have, in addition to a structural unit derived from a dimerdiol, a structural unit derived from a polyol other than dimerdiols. Herein, the expression "structural unit derived from a polyol other than dimerdiols" means a structure obtained by removing at least one end hydroxyl group from a polyol other than dimerdiols. As polyols other than dimerdiols, there may be mentioned the same ones as those mentioned in the description of the compound of present invention (I).

Considering the adhesion of the compound to glass and indium tin oxide (hereinafter referred to as ITO), preferably, the compound of present invention (II) is a compound having the group represented by formula (1) and the group represented by formula (2) as end groups, and having a group represented by the following formula (3) as a structural unit: 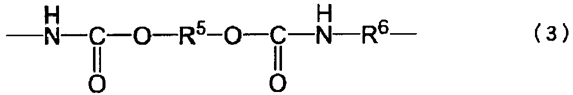 wherein R⁵ and R⁶ are the same as those described above.

In formula (3), when R⁶ is an organic residue derived from a diisocyanate compound, the compound of present invention (II) is represented by the following formula (10') : 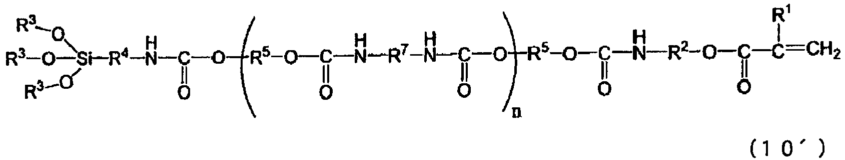 wherein n represents 0 or an integer of 1 to 20 and R¹, R², R³, R⁴, R⁵, and R⁷ are the same as those described above.

Next, a description will be given of a production method according to present invention (III).

Present invention (III) relates to a method for producing the compound of present invention (I), comprising conducting addition polymerization reaction using, as raw materials, the following (a1) to (a3):
(a1) dimerdiol;
(a2) a polyisocyanate compound comprising a diisocyanate compound;
(a3) a compound represented by formula (5): 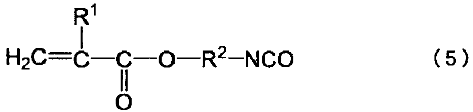
wherein R¹ represents H or CH₃ and R² represents a hydrocarbon group having 2 to 12 carbon atoms.

First, (a1) a dimerdiol used in the production method of present invention (III) is the same as the "dimerdiol" shown in the description of the compound of present invention (1) above.

Next, a description will be given of (a2) a polyisocyanate compound comprising a diisocyanate compound, used in the production method of present invention (III).

The polyisocyanate compound comprising a diisocyanate compound means one diisocyanate compound or a mixture of two or more polyisocyanates comprising at least one diisocyanate compound as an essential component.

The diisocyanate compound is not specifically restricted to any one as long as it is a compound having two isocyanate groups in one molecule. Examples of the diisocyanate compound include 1,4-cyclohexane diisocyanate, isophorone diisocyanate, methylenebis(4-cyclohexylisocyanate), 1,3-bis(isocyanatomethyl)cyclohexane, 1,4-bis(isocyanatomethyl)cyclohexane, 2,4- tolylene diisocyanate, 2,6-tolylene diisocyanate, diphenylmethane-4,4'-diisocyanate, 1,3-xylylene diisocyanate, 1,4-xylylene diisocyanate, lysine tri-isocyanate, lysine diisocyanate, hexamethylene diisocyanate, 2,4,4-trimethylhexamethylene diisocyanate, 2,2,4-trimethylhexane methylene diisocyanate, and norbornane diisocyanate.

To maintain moisture-proof capabilities at high level, 1,4-cyclohexane diisocyanate, isophorone diisocyanate, methylenebis(4-cyclohexylisocyanate), 1,3-bis(isocyanatomethyl)cyclohexane, 1,4-bis(isocyanatomethyl)cyclohexane, diphenylmethane-4,4'-diisocyanate, 1,3-xylylene diisocyanate, 1,4-xylylene diisocyanate, 2,4,4-trimethylhexamethylene diisocyanate, 2,2,4-trimethylhexanemethylene diisocyanate, and norbornane diisocyanate are preferable, and methylenebis(4-cyclohexylisocyanate), diphenylmethane-4,4'-diisocyanate, and norbornane diisocyanate are more preferable.

Examples of the polyisocyanate compound having three or more isocyanate groups in the molecule may include triphenylmethane triisocyanate and compounds having structures represented by the following formulas (19) to (21):

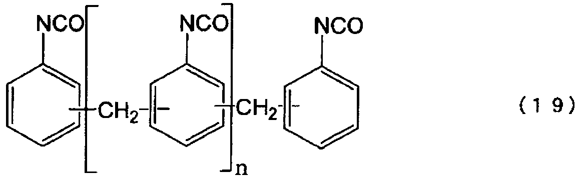

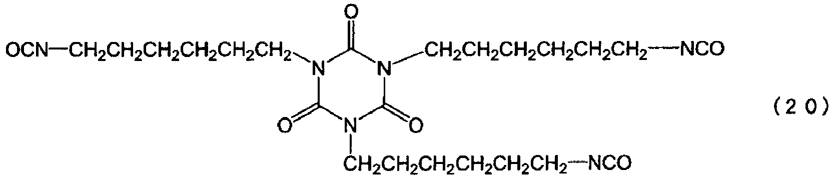

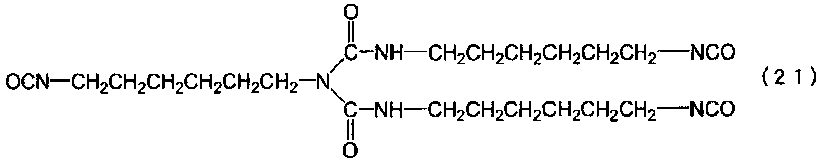

When using any of these polyisocyanate compounds having three or more isocyanate groups in the molecule, it is desirable to use the compound in a ratio that does not cause gelation.

Next, a description will be given of (a3) a compound represented by formula (5) used in the production method of present invention (III):

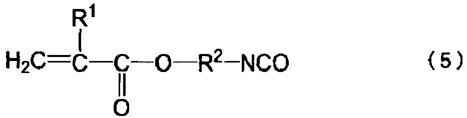

In formula (5), R¹ represents H or CH₃. When R¹ is H, it is meant that the compound represented by formula (5) has an acryloyl group at a molecular end thereof. In addition, when R¹ is CH₃, it is meant that the compound represented by formula (5) has a methacryloyl group at the molecular end thereof.

Preferably, R¹ in the compound represented by formula (5) is H from the viewpoint of accelerating the curing rate of the curable composition of present invention (V) described below.

In formula (5), R² represents a hydrocarbon group having 2 to 12 carbon atoms. From the viewpoint of accelerating the curing rate of the curable composition of present invention (V) described below, R² in the compound represented by formula (5) is preferably a hydrocarbon group having 2 to 8 carbon atoms, and more preferably a hydrocarbon group having 2 to 6 carbon atoms.

As the polyol component used in the production method of present invention (III), a polyol other than dimerdiols may be used in a range not deteriorating physical properties thereof.

Examples of polyols other than dimerdiols include chain aliphatic polyols other than dimerdiols, such as 1,3-propanediol, 1,4-butanediol, 1,3-butanediol, 1,5-pentanediol, neopentyl glycol, 3-methyl-1,5-pentanediol, 1,6-hexanediol, 2-methyl-1,8-octanediol, 1,9-nonanediol, 2-ethyl-2-butyl-1,3-propanediol, 2,4-diethyl-1,5-pentanediol, 1,10-decanediol, and 1,12-dodecanediol; polyols having an alicyclic structure other than dimerdiols, such as 1,4-cyclohexanedimethanol, 1,3-cyclohexanedimethanol, tricyclo[5.2.1.0^{2,6}]decane dimethanol, and 2-methylcyclohexane-1, 1-dimethanol; polyols having an aromatic ring, such as trimertriol, p-xylylene glycol, a bisphenol A ethylene oxide adduct, a bisphenol F ethylene oxide adduct, and a biphenol ethylene oxide adduct; polyether polyols such as polyethylene glycol, polypropylene glycol, and polytetramethylene glycol; polyester polyols such as poly(hexamethylene adipate), poly(hexamethylene succinate), and polycaprolactone; and (poly)carbonate diols such as α,ω-poly(1,6-hexylene carbonate)diol, α,ω-poly(3-methyl-1,5-pentylene carbonate)diol, α,ω-poly[(1,6-hexylene:3-methylpentamethylene)carbonate]diol, and α,ω-poly[(1,9-nonylene:2-methyl-1,8-octylene)carbonate]diol. Examples of those commercially available include PLACCEL CD-205, 205PL, 205HL, 210, 210PL, 210HL, 220, 220PL, and 220HL manufactured by Daicel Chemical Industries, Ltd., and KURARAY POLYOL C-590, C-1065N, C-1015N, and C-2015N manufactured by Kuraray Co., Ltd.

Among them, compounds preferable to maintain electrical insulation capabilities at high level and viscosity at relatively low level are chain aliphatic diols having 9 or more carbon atoms other than dimerdiols, such as 2-methyl-1,8-octanediol, 1,9-nonanediol, 2-ethyl-2-butyl-1,3-propanediol, 2,4-diethyl-1,5-pentanediol, 1,10-decanediol, and 1,12-dodecanediol; and (poly)carbonate diols having a structural unit derived from a chain aliphatic polyol having 6 or more carbon atoms of (poly)carbonate diol, such as α,ω-poly(1,6-hexylene carbonate)diol, α,ω-poly(3-methyl-1,5-pentylene carbonate)diol, α,ω-poly[(1,6-hexylene:3-methyl-pentamethylene) carbonate] diol, and α,ωo-poly[(1,9-nonylene:2-methyl-1,8-octylene)carbonate]diol.

In the production method of present invention (III), by the reaction of (a1), (a2), and (a3) in the presence or absence of a known urethane catalyst such as dibutyl tin dilaurylate, the compound can be synthesized. However, in view of the reduction of reaction time, preferably, the reaction is conducted in the presence of a catalyst. In this case, using too much of the catalyst can eventually have negative influence on values of physical properties in practical use as a cured film. Accordingly, the amount of catalyst to be used is preferably 0.001 to 1 parts by weight based on a total 100 parts by weight of (a1), (a2), and (a3). If the amount of catalyst is below 0.001 parts by weight, the addition of catalyst is substantially ineffective, whereas adding catalyst in an amount larger than 1 part by weight can eventually negatively influence on the values of physical properties when actually used as a cured film, as mentioned above.

Sequential order for mixing raw materials is not specifically restricted. Usually, (a1), then as needed, a polyol component other than dimerdiols (that is, other than (a1)), and as needed, an urethane catalyst are put into a reactor to stir. Then, at a reactor temperature of 50 to 140°C, preferably 60 to 120°C, (a2) is put thereinto, and after that, those materials are reacted with each other at a reactor temperature of 50 to 160°C, preferably 60 to 140°C. Next, the disappearance of isocyanate group is confirmed by IR spectrum or the like, and at a reactor temperature of 30 to 120°C, preferably 50 to 100°C, a polymerization inhibitor and, as needed, a urethane catalyst are added, followed by dropping of (a3). During the dropping, preferably, the temperature inside the reactor is maintained at 30 to 120°C, and desirably 50 to 100°C. After the completion of the dropping, the reactor temperature is maintained at 30 to 120°C, and desirably 50 to 100°C to complete the reaction.

A mixing ratio by mole of the raw materials (i.e., an amount by mole of hydroxyl groups in (a1) and polyol components other than (a1)/an amount by mole of isocyanate groups in (a2)/an amount by mole of isocyanate groups in (a3)) is adjusted according to the molecular weight of the intended polyurethane.

When the mole ratio of hydroxyl groups in (a1) and polyol components other than (a1) to isocyanate groups in (a2) is close to 1.0, the molecular weight becomes large, whereas it is deviated from 1.0 to be larger, the molecular weight becomes smaller.

The polymerization inhibitor includes, but is not limited to, hydroquinone, p-methoxyphenol, p-benzoquinone, naphthoquinone, phenanthraquinone, toluquinone, 2,5-diacetoxy-p-benzoquinone, 2,5-dicaproxy-p-benzoquinone, 2,5-acyloxy-p-benzoquinone, p-t-butylcatechol, 2,5-di-t-butylhydroquinone, p-tert-butylcatechol, mono-t-butylhydroquinone, 2,5-di-t-amylhydroquinone, di-t-butyl/paracresol hydroquinone monomethylether, alpha-naphthol, acetamidine acetate, acetamidine sulfate, phenylhydrazine hydrochloride, hydrazine hydrochloride, trimethylbenzylammonium chloride, laurylpyridium chloride, cetyltrimethylammonium chloride, phenyltrimethylammonium chloride, trimethylbenzylammonium oxalate, di-(trimethylbenzylammonium)oxalate, trimethylbenzylammonium malate, trimethylbenzyl ammonium tartrate, trimethylbenzylammonium glycolate, phenyl-β-naphthylamine, parabenzyl aminophenol, di-β-naphthyl paraphenylene diamine, dinitrobenzene, trinitrotoluene, picric acid, cyclohexanone oxime, pyrogallol, tannin, resorcin, triethylamine hydrochloride, dimethylaniline hydrochloride, and dibutylamine hydrochloride.

Those compounds can be used alone or in combinations of two or more types thereof.

Among them, suitably used are hydroquinone, p-methoxyphenol, p-benzoquinone, naphthoquinone, phenanthraquinone, toluquinone, 2,5-diacetoxy-p-benzoquinone, 2,5-dicaproxy-p-benzoquinone, 2,5-acyloxy-p-benzoquinone, p-t-butylcatechol, 2,5-di-t-butylhydroquinone, p-tert-butylcatechol, mono-t-butylhydroquinone, 2,5-di-t-amylhydroquinone, di-t-butyl/paracresol hydroquinone monomethylether, and phenothiazine.

Usually, the polymerization inhibitor is added preferably in an amount of 0.01 to 10 parts by weight, based on 100 parts by weight of a total of polymerizable components.

Next, a description will be given of a production method according to present invention (IV).

Present invention (IV) relates to a method for producing the compound of present invention (II), comprising conducting addition polymerization reaction using, as raw materials, the following (a1) to (a4):
(a1): a dimerdiol;
(a2): a polyisocyanate compound comprising a diisocyanate compound;
(a3): the compound represented by formula (5); and
(a4): a compound represented by formula (6): 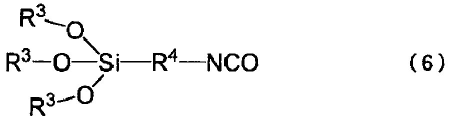
wherein R³s each independently represent CH₃ or CH₂CH₃, and R⁴ represents a hydrocarbon group having 3 to 9 carbon atoms.
Component (a1) used in the production method of present invention (IV) is the same as (a1) used in the description of the production method of present invention (III).
Component (a2) used in the production method of present invention (IV) is the same as (a2) used in the description of the production method of present invention (III).

Additionally, component (a3) used in the production method of present invention (IV) is the same as (a3) used in the description of the production method of present invention (III).

Next, a description will be given of (a4) a compound represented by formula (6) used in the production method of present invention (IV). 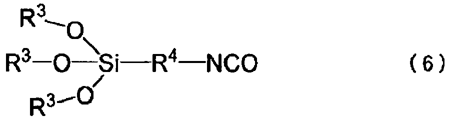 wherein R³s each independently represent CH₃ or CH₂CH₃, and R⁴ represents a hydrocarbon group having 3 to 9 carbon atoms.

In formula (6), the expression "R³s each independently" means that all of the three R³s of the end structure represented by formula (6) may have the same structure (i.e., all of the three R³s are CH₃ or CH₂CH₃), one of the three R³s may be CH₃ and the other two thereof may be CH₂CH₃, or the two thereof may be CH₃ and the remaining one thereof may be CH₂CH₃.

In formula (6), R⁴ represents a hydrocarbon group having 3 to 9 carbon atoms. Specificexamples of R⁴ may include structures of the following formulas (11) to (18):

-CH₂CH₂CH₂ (11)

CH₂CH₂CH₂CH₂ (12)

-CH₂CH₂CH₂CH₂CH₂- (13)

CH₂CH₂CH₂CH₂CH₂CH₂ (14)

-CH₂CH₂CH₂CH₂CH₂CH₂CH₂- (15)

-CH₂CH₂CH₂CH₂CH₂CH₂CH₂CH₂- (16)

-CH₂CH₂CH₂CH₂CH₂CH₂CH₂CH₂CH₂- (17)

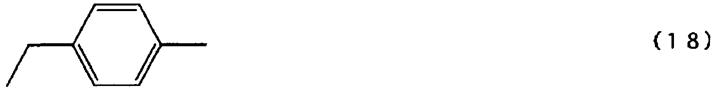

As the polyol component used in the production method of present invention (IV), a polyol other than dimerdiols may be used in a range not deteriorating the physical properties. Polyols other than dimerdiols may include the same polyols other than dimerdiols used in the description of the production method of present invention (III) above.

In the production method of present invention (IV), by the reaction of (a1), (a2), (a3) and (a4) in the presence or absence of a known urethane catalyst such as dibutyl tin dilaurylate, compound synthesis can be achieved. However, in view of the reduction of reaction time, preferably, the reaction is conducted in the presence of a catalyst. In this case, using too much amount of the catalyst can have negative influence on values of the physical properties in practical use as a cured film. Accordingly, the amount of a catalyst to be used is preferably 0.001 to 1 parts by weight based on 100 parts by weight of a total of (a1), (a2), (a3), and (a4). If the amount of catalyst is below 0.001 parts by weight, the addition of catalyst is substantially ineffective, whereas adding catalyst in an amount larger than 1 part by weight can eventually negatively influence on values of the physical properties when actually used as a cured film, as mentioned above.

Sequential order for mixing raw materials is not specifically restricted. Usually, (a1), then as needed, a polyol component other than dimerdiols (i.e., other than (a1)), and as needed, an urethane catalyst are put into a reactor to stir. Then, at the reactor temperature of 50 to 140°C, preferably 60 to 120°C, (a2) is put thereinto, and after that, those materials are reacted with each other at the reactor temperature of 50 to 160°C, preferably 60 to 140°C. Next, the disappearance of isocyanate group is confirmed by IR spectrum or the like, and at the reactor temperature of 30 to 120°C, preferably 50 to 100°C, a polymerization inhibitor and, as needed, an urethane catalyst are added, followed by dropping of (a3) and (a4). During the dropping, preferably, the temperature inside the reactor is maintained at 30 to 120°C, and desirably 50 to 100°C. After the completion of the dropping, the reactor temperature is maintained at 30 to 120°C, and desirably 50 to 100°C to complete the reaction.

A mixing ratio by mole of the raw materials (that is, an amount by mole of hydroxyl groups in (a1) and polyol components other than (a1)/an amount by mole of isocyanate groups in (a2)/an amount by mole of isocyanate groups in (a3) and (a4)) is adjusted according to the molecular weight of the intended polyurethane.

When a mole ratio of hydroxyl groups in (a1) and polyol components other than (a1) to isocyanate groups in (a2) is close to 1.0, the molecular weight becomes large, whereas the mole ratio is deviated from 1.0 to be larger, the molecular weight becomes smaller.

The polymerization inhibitor may include the same ones as those described in the production method of present invention (III) above. Usually, the polymerization inhibitor is added preferably in the amount of 0.01 to 10 parts by weight based on 100 parts by weight of a total of polymerizable components.

Next, a curable composition according to present invention (V) will be described.

Present invention (V) relates to a curable composition comprising the following components A, B, and C.
(Component A): the compound of present invention (I) and/or the compound of present invention (II);
(Component B): a non-silicon-containing monofunctional (meth)acryloyl group-containing compound;
(Component C): a photopolymerization initiator.

Component A of the curable composition of present invention (V) is the component of present invention (I) and/or the compound of present invention (II) of the present invention above.

Next, component B of the curable composition of present invention (V) will be described.

Component B of the curable composition of present invention (V) is a non-silicon-containing monofunctional (meth)acryloyl group-containing compound. Specifically, component B is not specifically restricted as long as it is a (meth)acryloyl group-containing compound containing no silicon atom in the molecule thereof and having one (meth)acryloyl group in a molecule other than component A.

Component B of present invention (V) has preferably a viscosity of 1 Pa·s or lower at 25°C, in view of dispersibility improvement in the curable composition and easy coatability of the curable composition.

Examples of the monofunctional (meth)acryloyl group-containing compound of component B include (meth)acryloyl-containing compounds having a cyclic ether group, such as glycidyl acrylate, tetrahydrofurfuryl acrylate, glycidyl methacrylate, and tetrahydrofurfuryl methacrylate, monofunctional (meth)acryloyl group-containing compounds having a cyclic aliphatic group, such as cyclohexyl acrylate, isobornyl acrylate, dicyclopentenyl acrylate, dicyclopentenyl oxyethyl acrylate, dicyclopentanyl acrylate, dicyclopentanyl ethyl acrylate, norbonyl acrylate, 4-tert-butylcyclohexyl acrylate, N-(acryloyloxyethyl)hexahydrophthalimide, cyclohexyl methacrylate, isobornyl methacrylate, dicyclopentenyl methacrylate, dicyclopentenyloxyethyl methacrylate, dicyclopentanyl methacrylate, dicyclopentanylethyl methacrylate, norbonyl methacrylate, 4-tert-butylcyclohexyl methacrylate, and N-(methacryloyloxyethyl)hexahydrophthalimide; monofunctional (meth)acryloyl group-containing compounds having a chain aliphatic group, such as lauryl acrylate, cetyl acrylate, isodecyl acrylate, isononyl acrylate, 2-ethylhexyl acrylate, isobutyl acrylate, tert-butyl acrylate, isooctyl acrylate, isoamyl acrylate, lauryl methacrylate, cetyl methacrylate, isodecyl methacrylate, isononyl methacrylate, 2-ethylhexyl methacrylate, isobutyl methacrylate, tert-butylmethacrylate, isooctyl methacrylate, and isoamyl methacrylate; monofunctional (meth)acryloyl group-containing compounds having an aromatic ring, such as benzyl acrylate, phenoxyethyl acrylate, 2-hydroxy-3-phenoxypropyl acrylate, benzyl methacrylate, phenoxyethyl methacrylate, 2-hydroxy-3-phenoxypropyl methacrylate, N-acryloyloxy ethyl phthalimide, and N-methacryloyloxy ethyl phthalimide.

Among these, preferable monofunctional (meth)acryloyl group-containing compounds are monofunctional (meth)acryloyl group-containing compounds having a cyclic aliphatic group, such as cyclohexyl acrylate, isobornyl acrylate, dicyclopentenyl acrylate, dicyclopentenyloxyethyl acrylate, dicyclopentanyl acrylate, dicyclopentanyloxyethyl acrylate, norbornyl acrylate, N-acryloyloxyethyl hexahydrophthalimide, cyclohexyl methacrylate, isobornyl methacrylate, dicyclopentenyl methacrylate, dicyclopentenyloxyethyl methacrylate, dicyclopentanyl methacrylate, dicyclopentanyl ethyl methacrylate, norbornyl methacrylate, and N-methacryloyloxyethyl hexahydrophthalimide; monofunctional (meth)acryloyl group-containing compounds having a chain aliphatic group, such as lauryl acrylate, cetyl acrylate, isodecyl acrylate, isononyl acrylate, 2-ethylhexyl acrylate, isobutyl acrylate, tert-butyl acrylate, isooctyl acrylate, isoamyl acrylate, lauryl methacrylate, cetyl methacrylate, isodecyl methacrylate, isononyl methacrylate, 2-ethylhexyl methacrylate, isobutyl methacrylate, tert-butylmethacrylate, isooctyl methacrylate, and isoamyl methacrylate; and more preferable ones are isobornyl acrylate, dicyclopentanyl acrylate, dicyclopentanyloxyethyl acrylate, lauryl acrylate, cetyl acrylate, isodecyl acrylate, isononyl acrylate, 2-ethylhexyl acrylate, and isooctyl acrylate.

The curable composition of present invention (V) can further comprise, and preferably does further comprise, a silane coupling agent (hereinafter referred to as component D) for the purpose of providing adhesion to glass, metal, or metal oxides.

Component D is an organic silicon compound simultaneously having a functional group reacting with and bonding to an organic material and a functional group reacting with and bonding to an inorganic material in the molecule thereof, and generally has a structure shown as in the following formula (19):

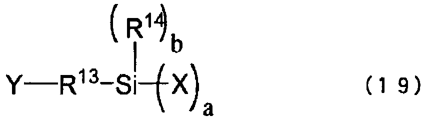

Herein, Y is a functional group reacting with and bonding to an organic material, and typical examples of the functional group include vinyl groups, epoxy groups, amino groups, substituted amino groups, (meth)acryloyl groups, and mercapto groups. X is a functional group reacting with an inorganic material and hydrolyzed with water or moisture to produce silanol. The silanol reacts with and bonds to an inorganic material. Typical examples of X include alkoxy groups, an acetoxy group, and a chlorine atom. R¹³ is a divalent organic group; R¹⁴ represents an alkyl group; a represents an integer of 1 to 3; and b represents an integer of 0 to 2, with the proviso that the sum of a + b is 3.

Examples of the silane coupling agent include 3-isocyanate propyltriethoxysilane, 3-isocyanate propyltrimethoxysilane, 3-isocyanate propylmethyl diethoxysilane, 3-isocyanate propylmethyl dimethoxysilane, p-styryl trimethoxysilane, p-styryl triethoxysilane, vinyltrimethoxysilane, vinyltriethoxysilane, vinyltriisopropoxysilane, vinyltris(2-methoxyethoxy)silane, 3-acryloyloxy propyltrimethoxysilane, 3-methacryloyloxy propyltrimethoxysilane, 3-acryloyloxy propyltriethoxysilane, 3-methacryloyloxy propyltriethoxysilane, 3-acryloyloxy propylmethyl dimethoxysilane, 3-methacryloyloxy propylmethyl dimethoxysilane, 3-acryloyloxy propylmethyl diethoxysilane, 3-methacryloyloxy propylmethyl diethoxysilane, 2-(3,4-epoxycyclohexyl)ethyltrimethoxysilane, 3-glycidoxypropyl trimethoxysilane, 3-glycidoxypropylmethyl dimethoxysilane, 3-glycidoxypropyl triethoxysilane, 3-glycidoxypropylmethyl diethoxysilane, N-2-(aminoethyl)-3-aminopropylmethyl dimethoxysilane, N-(2-minoethyl)-3-aminopropyltrimethoxysilane, N-(2-aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, 3-mercaptopropyl trimethoxysilane, 3-mercaptopropyl triethoxysilane, and allyltrimethoxysilane.

Among them, preferable silane coupling agents are compounds in which Y has reactivity with component A, and particularly preferable silane coupling agents are p-styryl trimethoxysilane, p-styryl triethoxysilane, vinyltrimethoxysilane, vinyltriethoxysilane, vinyltri(isopropoxy)silane, vinyltris(2-methoxyethoxy)silane, 3-acryloyloxy propyltrimethoxysilane, 3-methacryloyloxy propyltrimethoxysilane, 3-acryloyloxy propyltriethoxysilane, 3-methacryloyloxy propyltriethoxysilane, 3-acryloyloxy propylmethyl dimethoxysilane, 3-methacryloyloxy propylmethyl dimethoxysilane, 3-acryloyloxy propylmethyl diethoxysilane, and 3-methacryloyloxy propylmethyl diethoxysilane; and more preferable silane coupling agents are 3-acryloyloxy propyltrimethoxysilane, 3-methacryloyloxy propyltrimethoxysilane, 3-acryloyloxy propyltriethoxysilane, 3-methacryloyloxy propyltriethoxysilane, 3-acryloyloxy propylmethyl dimethoxysilane, 3-methacryloyloxy propylmethyl dimethoxysilane, 3-acryloyloxy propylmethyl dimethoxysilane, and 3-methacryloyloxy propylmethyl dimethoxysilane, which are easily incorporated into a cured product in photo-curing reaction. When considering the reactivity of alkoxysilyl group, particularly preferable silane coupling agents are 3-acryloyloxy propyltrimethoxysilane, 3-methacryloyloxy propyltrimethoxysilane, 3-acryloyloxy propylmethyl dimethoxysilane, and 3-methacryloyloxy propylmethyl dimethoxysilane.

The curable composition of present invention (V) can further include a non-silicon-containing compound having two or more (meth)acryloyl groups in one molecule other than component A.

Examples of the non-silicon-containing compound having two or more (meth)acryloyl groups in one molecule other than component A include multifunctional (meth)acryloyl group-containing compounds having a cyclic aliphatic group, such as tricyclodecane dimethanol diacrylate and tricyclodecane dimethanol dimethacrylate, multifunctional (meth)acryloyl group-containing compounds having an aromatic ring, such as 2,2-bis[4-(acryloyloxyethoxy)phenyl]propane, 2,2-bis[[4-(acryloyloxypoly(ethoxy)]phenyl]propane, 2,2-bis[4-(acryloyloxyethoxy)phenyl]methane, 2,2-bis[[4-(acryloyloxypoly(ethoxy)]phenyl]methane, 2,2-bis[4-(methacryloyloxyethoxy)phenyl]propane, 2,2-bis[[4-(methacryloyloxypoly(ethoxy)]phenyl)propane, 2,2-bis[4-(methacryloyloxyethoxy)phenyl]methane, and 2,2-bis[[4-(methacrylolyloxypoly(ethoxy)]phenyl]methane; and multifunctional (meth)acryloyl group-containing compounds having a chain aliphatic group, such as 1,9-nonamethylene diacrylate, 2-methyl-1,8-octylene diacrylate, 1,6-hexamethylene diacrylate, 3,-methyl-1,5-pentylene diacrylate, 2,4-diethyl-1,5-pentylene diacrylate, 1,5-pentamethylene diacrylate, 1,9-nonamethylene dimethacrylate, 2-methyl-1,8-octylene methacrylate, 1,6-hexamethylene dimethacrylate, 3-methyl-1,5-pentylene dimethacrylate, 2,4-diethyl-1,5-pentylene dimethacrylate, and 1,5-pentamethylene diacrylate.

Among those, preferable non-silicon-containing compounds having two or more (meth)acryloyl groups in one molecule other than component A are multifunctional (meth)acryloyl group-containing compounds having a cyclic aliphatic group, such as tricyclodecane dimethanol diacrylate, and tricyclodecane dimethanol dimethacrylate, and multifunctional (meth)acryloyl group-containing compounds having a chain aliphatic group derived from polyhydric alcohol having 6 or more carbon atoms, such as 1,9-nonamethylene diacrylate, 2-methyl-1,8-octylene diacrylate, 1,6-hexamethylene diacrylate, 3-methyl-1,5-pentylene diacrylate, 2,4-diethyl-1,5-pentylene diacrylate, 1,9-nonamethylene dimethacrylate, 2-methyl-1,8-octylene dimethacrylate, 1,6-hexamethylene dimethacrylate, 3-methyl-1,5-pentylene dimethacrylate, and 2,4-diethyl-1,5-pentylene dimethacrylate. More preferable ones are multifunctional acryloyl group-containing compounds having a cyclic aliphatic group, such as tricyclodecane dimethanol diacrylate, and multifunctional (meth)acryloyl group-containing compounds having a chain aliphatic groups derived from polyhydric alcohol having 8 or more carbon atoms, such as 1,9-nonamethylene diacrylate, 2-methyl-1,8-octylene diacrylate, 3-methyl-1,5-pentylene diacrylate, and 2,4-diethyl-1,5-pentylene diacrylate.

In the curable composition of present invention (V), component A is contained preferably in an amount of 25 to 70% by weight, and more preferably in an amount of 30 to 65% by weight, based on the total number of polymerizable components. When the content of component A is below 25% by weight based on the total number of polymerizable components, it can negatively influence on the electrical insulation characteristics and tenacity of a cured coating film, which is unfavorable. Conversely, when the content of component A is larger than 70% by weight, the viscosity of the mixture product is increased unfavorably.

The term "polymerizable component" described in the present specification means a compound that can be polymerized by radical polymerization, and the term "a total of polymerizable components" means a total amount of polymerizable components. Both components A and B are included by the polymerizable component. It is also meant that the polymerizable component includes a silane coupling agent having a radical polymerizable unsaturated group, such as p-styryl trimethoxysilane, p-styryl trimethoxysilane, 3-acryloyloxy propyltrimethoxysilane, 3-methacryloyloxy propyltrimethoxysilane, 3-acryloyloxy propyltriethoxysilane, 3-methacryloyloxy propyltriethoxysilane, 3-acryloyloxy propylmethyl dimethoxysilane, 3-methacryloyloxy propylmethyl dimethoxysilane, 3-acryloyloxy propylmethyl diethoxysilane, or 3-methacryloyloxy propylmethyl diethoxysilane, which is contained in the component D.

In addition, it is meant that the polymerizable component includes any of the above-mentioned multifunctional (meth)acryloyl group-containing compounds.

Component B is included in an amount of preferably 20 to 70% by weight, and more preferably 40 to 65% by weight thereof, based on a total of polymerizable components.

The multifunctional (meth)acryloyl group-containing compound is contained preferably in an amount of 0 to 10% by weight, and more preferably in an amount of 0 to 5% by weight, based on the total number of polymerizable components.

When component A does not contain any alkoxysilyl group, the content of component D is in a range preferably from 0.1 to 8% by weight, and more preferably from 0.3 to 5% by weight based on the total number of polymerizable components in the curable composition of present invention (V). When the content of component D is below 0.1% by weight, its adhesion to glass, metal, or metal oxides cannot be sufficiently exhibited, which is thus unfavorable. Conversely, when the content thereof is larger than 8% by weight, surface tack of the cured product tends to increase depending on the type of the silane coupling agent used.

Next, a description will be given of the photopolymerization initiator of component C of present invention (V).

The photopolymerization initiator is not specifically restricted as long as it is a compound generating radicals that contribute to the initiation of radical polymerization under the irradiation of light, such as a near-infrared ray, visible ray, or ultraviolet ray.

Specific examples of the photopolymerization initiator include acetophenone, 2,2-dimethoxy-2-phenylacetophenone, diethoxyacetophenone, 1-hydroxycyclohexylphenylketone, 1,2-hydroxy-2-methyl-1-phenylpropane-1-on, α-hydroxycyclohexylphenylketone, 2-hydroxy-2-methyl-1-phenylpropanone, 2-hydroxy-2-methyl-1-(4-isopropylphenyl)propanone, 2-hydroxy-2-methyl-1-(4-dodecylphenyl)propanone, and 2-hydroxy-2-methyl-1-[(2-hydroxyethoxy)phenyl]propanone, benzophenone, 2-methylbenzophenone, 3-methylbenzophenone, 4-methylbenzophenone, 4-methoxybenzophenone, 2-chlorobenzophenone, 4-chlorobenzophenone, 4-bromobenzophenone, 2-carboxybenzophenone, 2-ethoxycarbonyl-benzophenone, 4-bezoyl-4'-methyldiphenyl sulfide, benzophenone tetra-carboxylic acid or tetramethylester thereof, 4,4'-bis(dialkylamino)benzophenones (such as 4,4'-bis(dimethylamine)benzophenone, 4,4'-bis(dicyclohexylamino)benzophenone, 4,4'-bis(diethylamino)benzophenone, 4,4'-bis(dihydroxyethylamino)benzophenone, 4-methoxy-4'-dimethylaminobenzophenone, 4,4'-dimethoxybenzophenone, 4-dimethylaminobenzophenone, 4-dimethylaminoacetophenone, benzyl, anthraquinone, 2-t-butylanthraquinone, 2-methylanthraquinone, phenanthraquinone, fluorenone, 2-benzyl-dimethylamino-1-(4-morpholinophenyl)-1-butanone, 2-methyl-1-[4-(methylthio)phenyl]-2-morpholino-1-propanone, 2-hydroxy-2-methyl-[4-(1-methylvinyl)phenyl]propanol oligomer, benzoin, benzoin ethers (such as benzoin methyl ether, benzoin ethyl ether, benzoin propyl ether, benzoin isopropyl ether, benzoin isobutyl ether, benzoin phenyl ether, and benzyl dimethyl ketal), acridone, chloroacridone, N-methyl acridone, N-butyl acridone, N-butyl-chloroacridone, 2,4,6-trimethylbenzoyl diphenylphosphine oxide, 2,6,-dimethoxybenzoyl diphenylphosphine oxide, 2,6-dichlorobenzoyl diphenylphosphine oxide, 2,4,6-trimethylbenzoyl methoxyphenyl phosphine oxide, 2,4,6-trimethylbenzoyl ethoxyphenyl phosphine oxide, 2,3,5,6-tetramethylbenzoyl diphenyl phosphine oxide, and benzoyl di-(2,6-dimethylphenyl)phosphonate. Examples of bis acyl phosphine oxides include bis-(2,6-dichlorobenzoyl)phenyl phosphine oxide, bis-(2,6-dichlorobenzoyl)-2,5-dimethylphenyl phosphine oxide, bis-(2,6-dichlorobenzoyl)-4-propylphenyl phosphine oxide, bis-(2,6-dichlorobenzoyl)-1-naphthyl phosphine oxide, bis-(2,6-dimethoxybenzoyl)phenyl phosphine oxide, bis-(2,6-dimethoxybenzoyl)-2,4,4-trimethylpentyl phosphine oxide. bis-(2,6-dimethoxybenzoyl)-2,5-dimethylphenyl phosphine oxide, bis-(2,4,6-trimethylbenzoyl)phenyl phosphine oxide, (2,5,6-trimethylbenzoyl)-2,4,4-trimethylpentyl phosphine oxide, 2-isopropylthioxanthone, 4-isopropylthioxanthone, 2,4-diethylthioxanthone, 2,4-dichlorothioxanthone, and 1-chloro-4-propoxythioxanthone.

Alternatively, the photopolymerization initiator may be a metallocene compound. Examples of metallocene compounds include metallocene compounds containing, as the central metal, typical transition elements, such as Fe, Ti, V, Cr, Mn, Co, Ni, Mo, Ru, Rh, Lu, Ta, W, Os, and Ir. Among them, titanocene compounds are preferable. Among titanocene compounds, bis(r)5-2,4-cyclopentadiene-1-yl)-bis[2,6-difluoro-3-(pyrrole-1-yl)phenyl]titanium is most preferable.

The amount of component C used in the curable composition of present invention (V) is preferably 0.05 to 15 parts by weight, and more preferably 0.5 to 6 parts by weight, based on 100 parts by weight of a total of polymerizable components. Those photopolymerization initiators may be used alone or in combinations of two or more kinds thereof.

In the curable composition of present invention (V), a radical chain transfer agent may be used as needed.

As the radical chain transfer agent, a compound that serves to reactivate polymerization active species trapped by a radical scavenger capturing an inactive radical such as oxygen to contribute to the improvement of surface curability can be unlimitedly used. Examples of the chain transfer agent include N,N-dimethylaniline, N,N-dimethyl-p-toluidine, N,N-dimethyl-m-toluidine, N,N-diethyl-p-toluidine, N,N-dimethyl-3,5-dimethylaniline, N,N-dimethyl-3,4-dimethylaniline, N,N-dimethyl-4-ethylaniline, N,N-dimethyl-4-isopropylaniline, N,N-dimethyl-4-t-butylaniline, N,N-dimethyl-3,5-di-t-butylaniline, N,N-bis(2-hydroxyethyl)-3,5dimethylaniline, N,N-di(2-hydroxyethyl)-p-toluidine, N,N-bis(2-hydroxyethyl)-3,4-dimethylaniline, N,N-bis(2-hydroxyethyl)-4-ethylaniline, N,N-bis(2-hydroxyethyl)-4-isopropylaniline, N,N-bis(2-hydroxyethyl)-4-t-butylaniline, N,N-bis(2-hydroxyethyl)-3,5-di-isopropylaniline, N,N-bis(2-hydroxyethyl)-3,5-di-t-butylaniline, ethyl 4-N,N-dimethylaminobenzoate, methyl 4-N,N-dimethylaminobenzoate, n-butoxyethyl N,N-dimethylaminobenzoate, 2-(methacryloyloxy)ethyl 4-N,N-dimethylaminobenzoate, 4-N,N-dimethylaminobenzophenone, trimethylamine, triethylamine, N-methyl diethanolamine, N-ethyl diethanolamine, N-n-butyl diethanolamine, N-lauryl diethanolamine, triethanolamine, 2-(dimethylamino)ethyl methacrylate, N-methyldiethanolamine dimethacrylate, N-ethyldiethanolamine dimethacrylate, triethanolamine monomethacrylate, triethanolamine dimethacrylate, and triethanolamine trimethacrylate. Particularly suitable amines are 2-ethylhexyl-4-dimethylaminobenzoates.

In the curable composition of present invention (V), when the radical chain transfer agent is used, a preferable amount of the agent is 0.01 to 10 parts by weight based on 100 parts by weight of a total of polymerizable components, whereby high sensitivity is obtained, improving the surface curability of the composition in the air. More preferably, the amount of the radical chain transfer agent is in a range of 0.5 to 5 parts by weight, whereby the surface curability of the composition is further improved. Those radical chain transfer agents may be used alone or in combinations of two or more types thereof.

A preferable viscosity of the curable composition of present invention (V) at 25°C is 6 Pa·s or lower, and a more preferable viscosity thereof at 25°C is 5 Pa·s or lower. When the viscosity thereof at 25°C is higher than 6 Pa·s, spreading of the curable composition dispensed is suppressed when dispensing the curable composition by a line-dispensing method using a dispenser. This can result in an unnecessary increase in the thickness of the cured composition.

Next, a description will be given of a photocurable moisture-proof insulating coating material for mounting circuit boards according to present invention (VI).

Present invention (VI) is a photocurable moisture-proof insulating coating material for mounting circuit boards, comprising the curable composition of present invention (V).

The photocurable moisture-proof insulating coating material for mounting circuit boards of present invention (V) comprises the curable composition of present invention (V). In other words, the curable composition of present invention (V) can be used for the photocurable moisture-proof insulating coating material. In this case, as needed, a filler, a polymerization inhibitor, a modifier, an antifoaming agent, a coloring agent, and the like can be arbitrarily added to the curable composition of present invention (V).

Examples of the filler include fine powdered silicon oxide, magnesium oxide, aluminium hydroxide, and calcium carbonate. The filler can be added in an amount of 0.01 to 100 parts by weight based on 100 parts by weight of a total of polymerizable components.

Examples of the polymerization inhibitor can be the same as those mentioned in the production method of present invention (III). Usually, the polymerization inhibitor can be adjusted such that an amount of the inhibitor added is 0.01 to 10 parts by weight based on 100 parts by weight of a total of polymerizable components. However, the amount of the polymerization inhibitor means a value including the amount of the polymerization inhibitor contained in advance in present invention (V). That is, in general, the curable composition of present invention (V) includes a polymerization inhibitor in advance, and the above description means that the total of an amount of this polymerization inhibitor and a sum of a newly added polymerization inhibitor is 0.01 to 10 parts by weight based on 100 parts by weight of a total of polymerizable components.

Examples of the modifier include a leveling agent for improving leveling properties and the like. Examples of the leveling agent include a polyether-modified dimethylpolysiloxane copolymer, a polyester-modified dimethylpolysiloxane copolymer, a polyether-modified methylalkylpolysiloxane copolymer, and an aralkyl-modified methylalkylpolysiloxane copolymer. These compounds may be used alone or in combinations of two or more types thereof and can be added in an amount of 0.01 to 10 parts by weight based on 100 parts by weight of a total of polymerizable components. When the amount of the leveling agent is below 0.01 parts by weight, the addition of the leveling agent can be ineffective. Conversely, when it exceeds 10 parts by weight, surface tack can be caused or electrical insulation characteristics can be deteriorated depending on the type of the leveling agent used.

The antifoaming agent mentioned above is not specifically restricted as long as it serves to eliminate or prevent bubbles generated or remaining when applying the curable composition of present invention (V) as the photocurable moisture-proof insulating coating material for mounting circuit boards.

Examples of the antifoaming agent used in the photocurable moisture-proof insulating coating material for mounting circuit boards of present invention (VI) include known antifoaming agents, such as silicone-based oil, fluorine-containing compounds, polycarboxylic acid-based compounds, polybutadiene-based compounds, and acetylenediol-based compounds. Specific examples of the antifoaming agent include silicone-based antifoaming agents such as BYK-077 manufactured by BYK-Chemmie Japan, Inc., SN-DEFOAMER 470 manufactured by San Nopco Limited., TSA 750S manufactured by Momentive Performance Materials LLC., and silicone oil SH-203 manufactured by Toray-Dow Corning Co., Ltd., acrylic copolymer-based antifoaming agents such as DAPPO SN-348 manufactured by San Nopco Ltd., DAPPO SN-354 manufactured by San Nopco Ltd., DAPPO SN-368 manufactured by San Nopco Ltd., and DISPARLON 230HF manufactured by Kusumoto Chemicals, Ltd., acetylenediol-based antifoaming agents such as SURFYNOL DF-110D manufactured by Nisshin Chemical Industry Co., Ltd. and SURFYNOL DF-37 manufactured by Nisshin Chemical Industry Co., Ltd., and fluorine-containing silicone-based antifoaming agents such as FA-630. These agents may be used alone or in combinations of two or more types thereof. Usually, the antifoaming agent can be added in an amount of 0.001 to 5 parts by weight based on 100 parts by weight of a total of polymerizable components. When the amount of the antifoaming agent is below 0.01 parts by weight, the addition of the antifoaming agent can be ineffective. Conversely, when it is more than 5 parts by weight, surface tack can occur or electrical insulation characteristics can deteriorate depending on the type of the antifoaming agent used.

Examples of the coloring agent include known inorganic pigments, known organic pigments, and known organic-based dyes, each of which is mixed according to the intended color tone. These may be used alone or in combinations of two or more types thereof. Usually, the pigments and the dyes can be added in an amount of 0.01 to 50 parts by weight based on 100 parts by weight of a total of polymerizable components.

The photocurable moisture-proof insulating coating material for mounting circuit boards of present invention (VI) has a viscosity at 25°C of preferably 6 Pa·s or lower, and more preferably 5 Pa·s or lower. When the viscosity at 25°C is higher than 6 Pa·s, spreading of the photocurable moisture-proof insulating coating material dispensed is suppressed when dispensing the coating material by the line dispensing method using a dispenser. This can result in an unnecessary increase in the thickness of the material cured.

Next, an electronic component of present invention (VII) will be described.

Present invention (VII) is an electronic component insulated with the photocurable moisture-proof insulating coating material for mounting circuit boards of present invention (VI). Examples of the electronic component include a microcomputer, a transistor, a capacitor, a resistor, a relay, and a transformer, as well as mounting circuit boards where those components are mounted. In addition, the electronic component can include a lead-wire, harness, and film substrate bonded to the electronic components.

Examples of the electronic component can further include signal input sections of flat panel display panels such as liquid crystal display panels, plasma display panels, organic electroluminescence panels, and field emission display panels. Particularly, the photocurable moisture-proof insulating coating material can be preferably used for an IC's peripheral region, a panel-bonding portion, and the like of display substrates for electronic components.

Lastly, a description will be given of a method for producing the electronic component of present invention (VII).

The electronic component of present invention (VII) can be produced by applying the photocurable moisture-proof insulating coating material for mounting circuit boards of present invention (VI) on an electronic component and then curing the applied photocurable moisture-proof insulating coating material for mounting circuit boards to insulate the electronic component.

The electronic component of present invention (VII) is produced by insulating an electronic component with the photocurable moisture-proof insulating coating material. Specifically, as a method for producing the electronic component of present invention (VII), first, the above moisture-proof insulating coating material is applied on the above electronic component by a commonly known technique, such as immersion, brushing, spraying, or line-dispensing. Next, using a light source such as a high-pressure mercury vapor lamp, a metal halide lamp, or an LED, UV light irradiation is performed to cure a coating film of the moisture-proof insulating coating material applied on the electronic component, thereby obtaining an electronic component. Particularly, the photocurable moisture-proof insulating coating material is applied to the IC's peripheral region and panel-bonding portion of display panel substrates for electronic component or the like by a dispenser device or the like and then cured by delivering a required dose of UV light using a lamp or LED-style UV irradiation apparatus to produce the electronic component.

### EXAMPLES

Hereinafter, the present invention will be described in more detail by Examples. However, the invention is not limited only to the Examples below.

### <Measurement of Viscosity>

The viscosity was measured by the following method.

Approximately 0.8 g of a sample was used to measure a value at which the viscosity became almost constant under the conditions: temperature 25.0°C and rotation rate 10 rpm, using a cone/plate viscometer (Type: DV-II+Pro; Model No. of Spindle: CPE-42, manufactured by Brookfield Co. Ltd).

### (Synthesis Example 1)

Into a 300 mL reaction container equipped with a stirrer, a thermometer, and a condenser, 87.5 g of PRIPOL^{®} 2033 [a hydrogenated dimerdiol having a hydroxyl value of 205.0 mgKOH/g, manufactured by Croda Inc.] was placed and continuously stirred until the temperature inside the reaction container increased up to 160°C in an oil bath. Then, the temperature thereinside was cooled down to 120°C, and 20.0 g (79.9 mmol) of flake-like diphenylmethane-4,4'-diisocyanate (COSMONATE^{®} PH(F) manufactured by Mitsui Chemicals, Inc.) was placed therein. The mixture was continuously stirred until the temperature inside the reaction container increased up to 160°C. After the temperature increased up to 160°C, the reaction was continued while stirring for 4 hours. Then, an infrared absorption spectrum was measured to confirm the complete disappearance of isocyanate group, and the inside temperature was decreased to 80°C while continuously stirring. After that, 0.13 g of hydroquinone monomethyl ether and 0.05 g of dioctyltin dilaurate were added into the reaction container, followed by dropping of 22.6 g (159.8 mmol) of 2-acryloyloxyethyl isocyanate (KARENZ^{®} AOI manufactured by Showa Denko K.K.) in 1 hour. During the dropping, the temperature inside the reaction container was maintained in a range of 80 to 90°C. After the completion of the dropping, the reaction was continued at 80°C for 3 hours. Then, an infrared absorption spectrum was measured to confirm the disappearance of absorption of isocyanate group, and the reaction was terminated to obtain urethane acrylate (hereinafter referred to as urethane acrylate A).

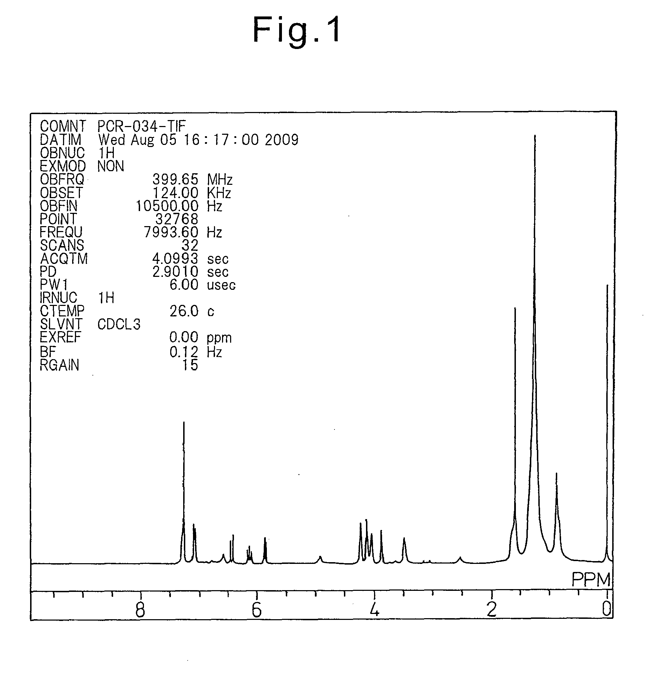

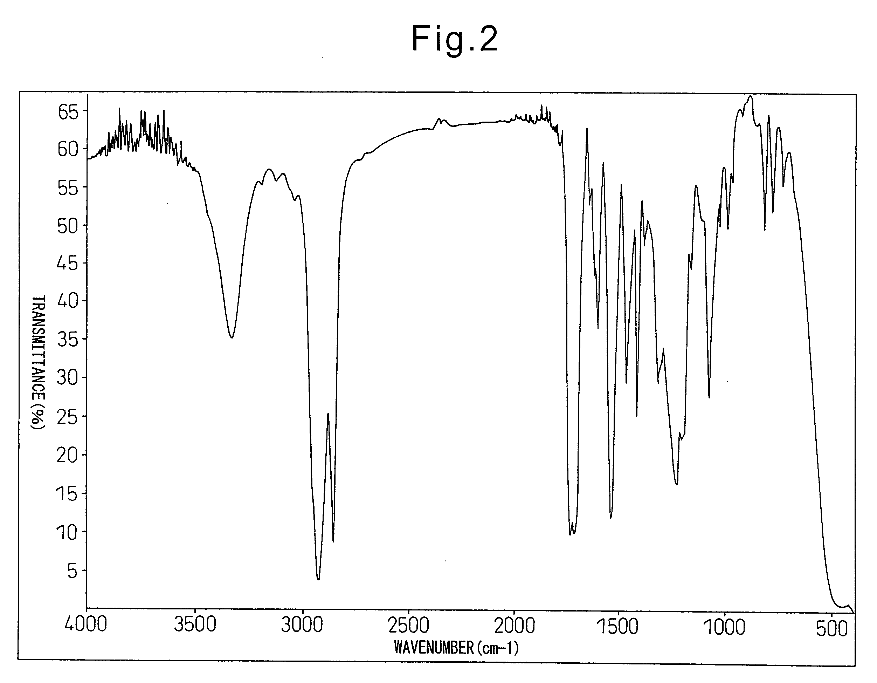

Figs. 1 and 2, respectively, show ¹H-NMR spectrum (solvent: CDCl₃) and IR spectrum, respectively, of urethane acrylate A.

### (Synthesis Example 2)

Into a 300 mL reaction container equipped with a stirrer, a thermometer, and a condenser, 91.2 g of PRIPOL^{®} 2033 [a hydrogenated dimerdiol having a hydroxyl value of 205.0 mgKOH/g, manufactured by Croda Inc.] was placed and continuously stirred until the temperature inside the reaction container increased up to 160°C in an oil bath. Then, the temperature thereinside was cooled down to 120°C, and 20.86 g (83.3 mmol) of flake-like diphenylmethane-4,4'-diisocyanate (COSMONATE^{®} PH(F) manufactured by Mitsui Chemicals, Inc.) was placed. The mixture was continuously stirred until the temperature inside the reaction container increased up to 160°C. After the temperature increased up to 160°C, the reaction was continued while stirring for 4 hours. Then, an infrared absorption spectrum was measured to confirm the complete disappearance of isocyanate group, and the inside temperature was decreased to 80°C while continuously stirring. After that, 0.1 g of hydroquinone monomethyl ether and 0.05 g of dioctyltin dilaurate were added into the reaction container, followed by dropping of 22.0 g (155.7 mmol) of 2-acryloyloxyethyl isocyanate (KARENZ^{®} AOI manufactured by Showa Denko K.K.) in 1 hour. During the dropping, the temperature inside the reaction container was maintained in the range of 80 to 90°C. After the completion of the dropping, the reaction was continued at 80°C for 3 hours. Then, an infrared absorption spectrum was measured to confirm the disappearance of absorption of isocyanate group, and the temperature inside the reaction container was cooled down to 70°C. Next, 2.25 g (11.0 mmol) of γ-isocyanatopropyl trimethoxysilane (product name: Y-5187 manufactured by Momentive Performance Materials LLC.) was added. The mixture was furthermore continuously stirred, and while maintaining the temperature inside the reaction container in a range of 70 to 80°C, the reaction was continued for 3 hours. After that, an infrared absorption spectrum was measured to confirm the disappearance of absorption of isocyanate group, and the reaction was terminated to obtain urethane acrylate (hereinafter referred to as urethane acrylate B).

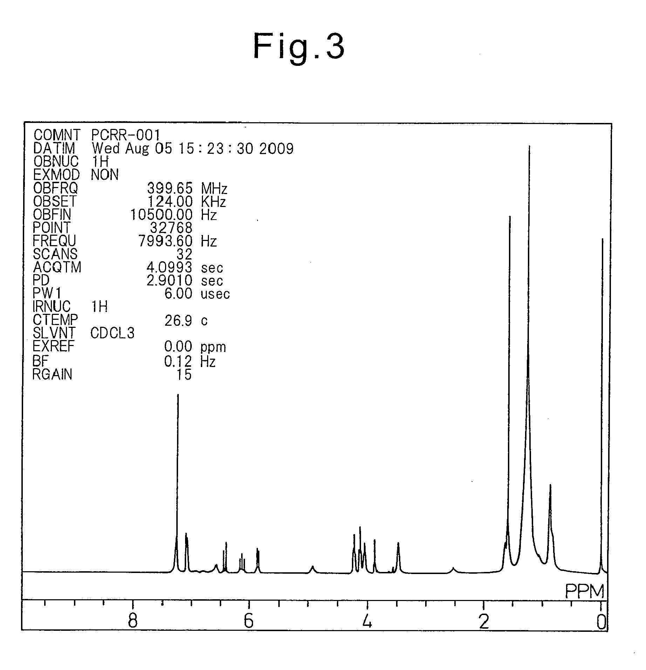

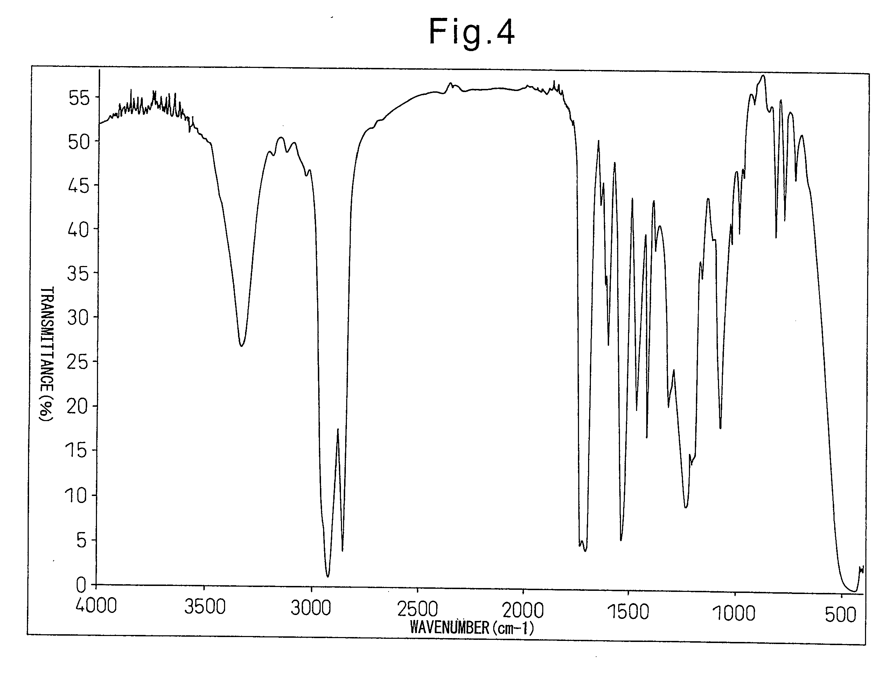

Figs. 3 and 4, respectively, show ¹H-NMR spectrum (solvent: CDCl₃) and IR spectrum, respectively, of urethane acrylate B.

### (Synthesis Example 3)

Into a 300 mL reaction container equipped with a stirrer, a thermometer, and a condenser, 91.2 g of PRIPOL^{®} 2033 [a hydrogenated dimerdiol having a hydroxyl value of 205.0 mgKOH/g, manufactured by Croda Inc.] was placed and continuously stirred until the temperature inside the container increased up to 160°C in an oil bath. Then, the temperature thereinside was cooled down to 120°C, and 20.86 g (83.3 mmol) of flake-like diphenylmethane-4,4'-diisocyanate (COSMONATE^{®} PH(F) manufactured by Mitsui Chemicals, Inc.) was placed therein. The mixture was continuously stirred until the inside temperature increased to 160°C. After the temperature increased up to 160°C, the reaction was continued while stirring for 4 hours. Then, an infrared absorption spectrum was measured to confirm the complete disappearance of isocyanate group, and the inside temperature was decreased to 80°C while continuously stirring. After that, 0.1 g of hydroquinone monomethyl ether and 0.05 g of dioctyltin dilaurate were added into the reaction container, followed by dropping of 22.0 g (155.7 mmol) of 2-acryloyloxyethyl isocyanate (KARENZ^{®} AOI manufactured by Showa Denko K.K.) in 1 hour. During the dropping, the temperature inside the reaction container was maintained from 80 to 90°C. After the completion of the dropping, the reaction was continued at 80°C for 3 hours. Then, an infrared absorption spectrum was measured to confirm the disappearance of absorption of isocyanate group, and the temperature inside the reaction container was cooled down to 70°C. Next, 2.25 g (9.1 mmol) of γ-isocyanatopropyl trimethoxysilane (product name: A-1310 manufactured by Momentive Performance Materials LLC.) was added. The mixture was furthermore continuously stirred, and while maintaining the temperature inside the reaction container from 70 to 80°C, the reaction was continued for 3 hours. After that, an infrared absorption spectrum was measured to confirm the disappearance of absorption of isocyanate group, and the reaction was terminated to obtain urethane acrylate (hereinafter referred to as urethane acrylate C).

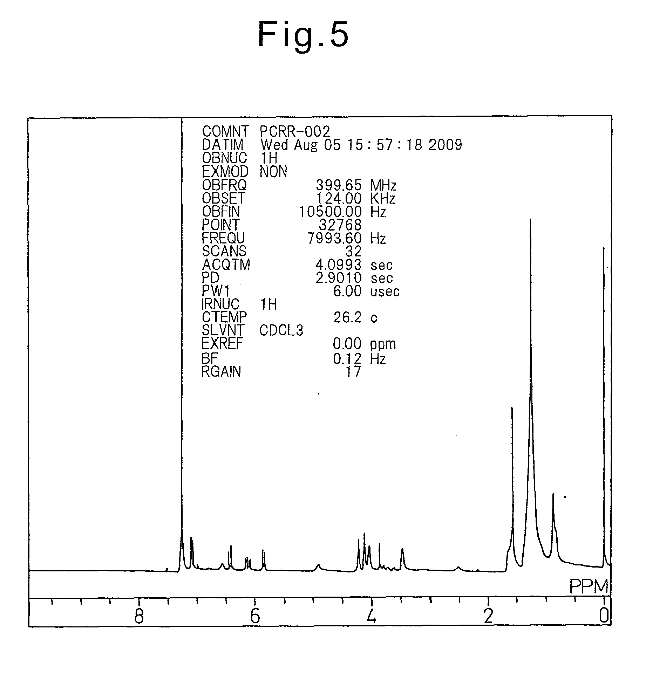

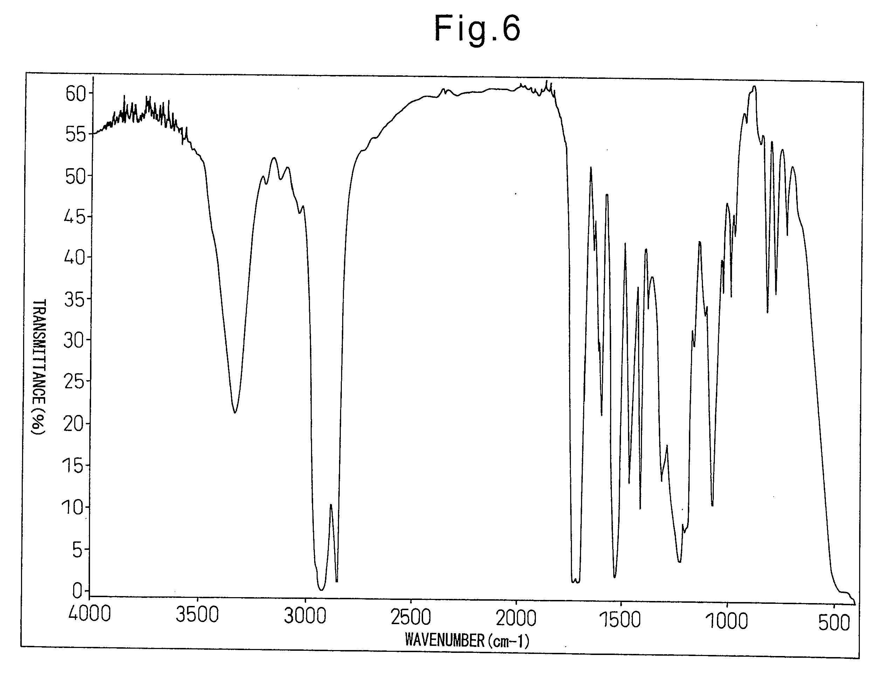

Figs. 5 and 6, respectively, show ¹H-NMR spectrum (solvent: CDCl₃) and IR spectrum, respectively, of urethane acrylate C.

### (Synthesis Example 4)

Into a 300 mL reaction container equipped with a stirrer, a thermometer, and a condenser, 91.2 g of PRIPOL^{®} 2033 [a hydrogenated dimerdiol having a hydroxyl value of 205.0 mgKOH/g, manufactured by Croda Inc.] was placed and continuously stirred until the temperature inside the reaction container increased up to 160°C in an oil bath. Then, the temperature thereinside was cooled down to 120°C, and 20.86 g (83.3 mmol) of flake-like diphenylmethane-4,4'-diisocyanate (COSMONATE^{®} PH(F) manufactured by Mitsui Chemicals, Inc.) was placed therein. The mixture was continuously stirred until the inside temperature increased up to 160°C. After the temperature increased to 160°C, the reaction was continued while stirring for 4 hours. Then, an infrared absorption spectrum was measured to confirm the complete disappearance of isocyanate group, and the inside temperature was decreased to 80°C while continuously stirring. After that, 0.1 g of hydroquinone monomethyl ether and 0.05 g of dioctyltin dilaurate were added into the reaction container, followed by dropping of 22.2 g (157.6 mmol) of 2-acryloyloxyethyl isocyanate (KARENZ^{®} AOI manufactured by Showa Denko K.K.) in 1 hour. During the dropping, the temperature inside the reaction container was maintained in the range of 80 to 90°C. After the completion of the dropping, the reaction was continued at 80°C for 3 hours. Then, an infrared absorption spectrum was measured to confirm the disappearance of absorption of isocyanate group, and the temperature inside the reaction container was cooled down to 70°C. Next, 1.13 g (5.5 mmol) of γ-isocyanatopropyl trimethoxysilane (product name: Y-5187 manufactured by Momentive Performance Materials LLC.) was added. The mixture was furthermore continuously stirred, and while maintaining the temperature inside the reaction container from 70 to 80°C, the reaction was continued for 3 hours. After that, an infrared absorption spectrum was measured to confirm the disappearance of absorption of isocyanate group, and the reaction was terminated to obtain urethane acrylate (hereinafter referred to as urethane acrylate D).

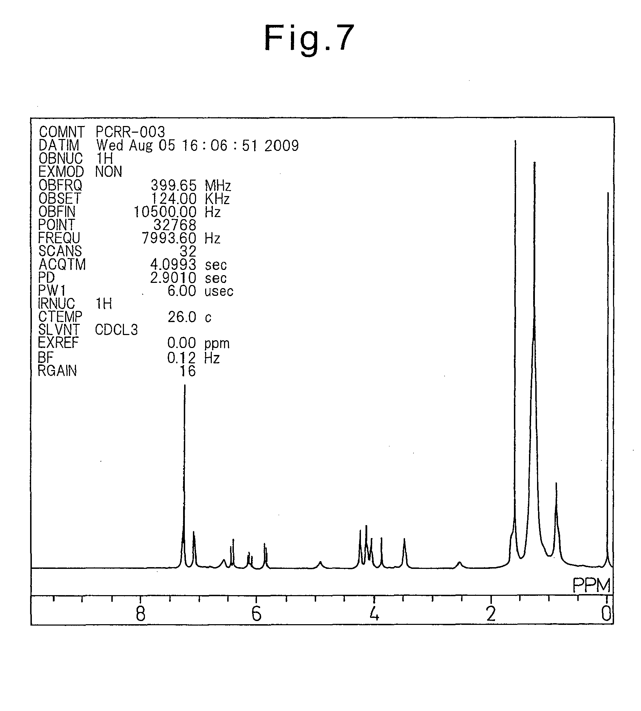

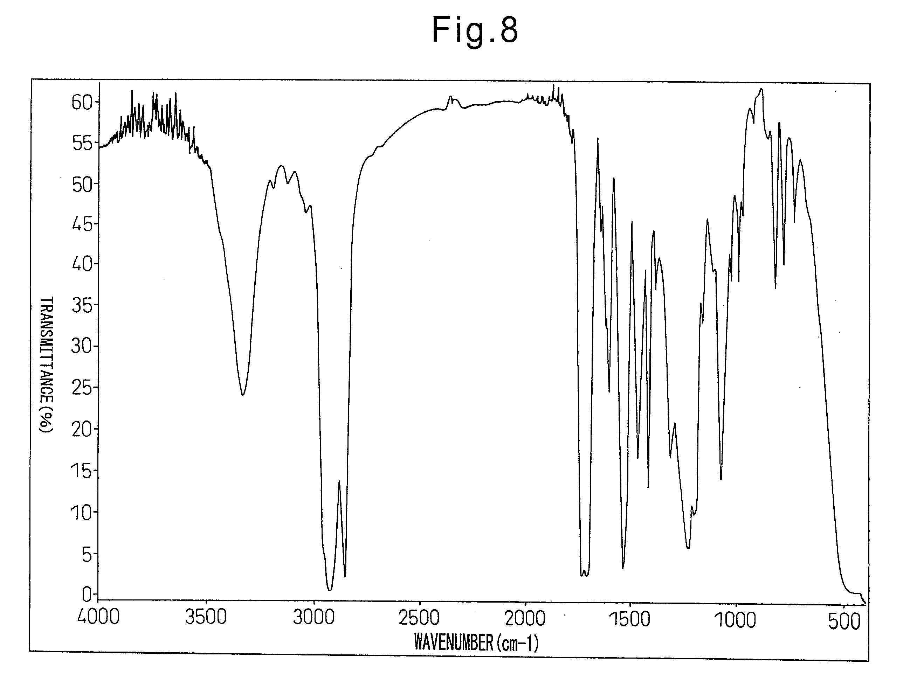

Figs. 7 and 8, respectively, show ¹H-NMR spectrum (solvent: CDCl₃) and IR spectrum, respectively, of urethane acrylate D.

### (Synthesis Example 5)

Into a 300 mL reaction container equipped with a stirrer, a thermometer, and a condenser, 91.2 g of PRIPOL^{®} 2033 [a hydrogenated dimerdiol having a hydroxyl value of 205.0 mgKOH/g, manufactured by Croda Inc.] was placed and continuously stirred until the temperature inside the reaction container increased up to 160°C in an oil bath. Then, the temperature thereinside was cooled down to 120°C, and 20.86 g (83.3 mmol) of flake-like diphenylmethane-4,4'-diisocyanate (COSMONATE^{®} PH(F) manufactured by Mitsui Chemicals, Inc.) was placed therein. The mixture was continuously stirred until the inside temperature increased to 160°C. After the temperature increased to 160°C, the reaction was continued while stirring for 4 hours. Then, an infrared absorption spectrum was measured to confirm the complete disappearance of isocyanate group, and the inside temperature was decreased to 80°C while continuously stirring. After that, 0.1 g of hydroquinone monomethyl ether and 0.05 g of dioctyltin dilaurate were placed into the reaction container, followed by dropping of 25.9 g (166.7 mmol) of 2-methacryloyloxyethyl isocyanate (KARENZ^{®} MOI manufactured by Showa Denko K.K.) in 1 hour. During the dropping, the temperature inside the reaction container was maintained from 80 to 90°C. After the completion of the dropping, the reaction was continued at 80°C for 3 hours. Then, an infrared absorption spectrum was measured to confirm the disappearance of absorption of isocyanate group, and the reaction was terminated to obtain urethane acrylate (hereinafter referred to as urethane acrylate E).

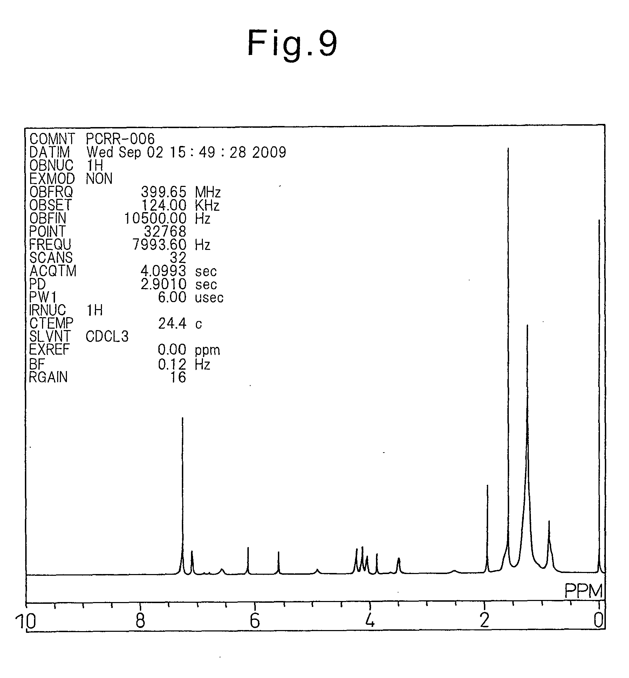

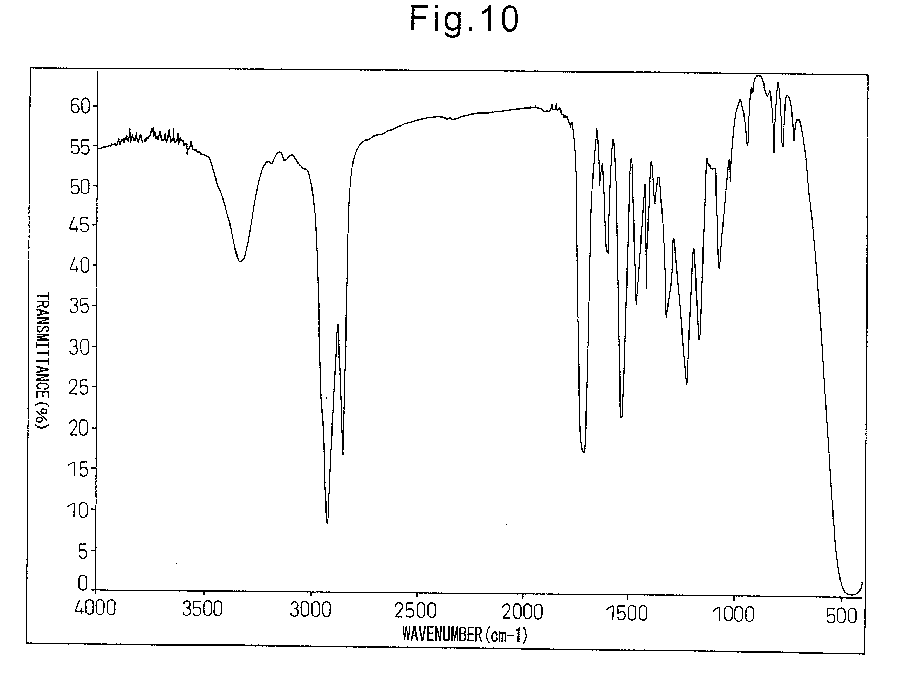

Figs. 9 and 10, respectively, show ¹H-NMR spectrum (solvent: CDCl₃) and IR spectrum, respectively, of urethane acrylate E.

### (Synthesis Example 6)

Into a 300 mL reaction container equipped with a stirrer, a thermometer, and a condenser, 91.2 g of PRIPOL^{®} 2033 [a hydrogenated dimerdiol having a hydroxyl value of 205.0 mgKOH/g, manufactured by Croda Inc.] was placed and continuously stirred until the temperature inside the reaction container increased to 160°C in an oil bath. Then, the temperature thereinside was cooled down to 120°C, and 20.86 g (83.3 mmol) of flake-like diphenylmethane-4,4'-diisocyanate (COSMONATE^{®} PH(F) manufactured by Mitsui Chemicals, Inc.) was placed therein. The mixture was continuously stirred until the inside temperature increased up to 160°C. After the temperature increased up to 160°C, the reaction was continued while stirring for 4 hours. Then, an infrared absorption spectrum was measured to confirm the complete disappearance of isocyanate group, and the inside temperature was decreased to 80°C while continuously stirring. After that, 0.1 g of hydroquinone monomethyl ether and 0.05 g of dioctyltin dilaurate were placed into the reaction container, followed by dropping of 24.2 g (155.7 mmol) of 2-methacryloyloxyethyl isocyanate (KARENZ^{®} MOI manufactured by Showa Denko K.K.) in 1 hour. During the dropping, the temperature inside the reaction container was maintained from 80 to 90°C. After the completion of the dropping, the reaction was continued at 80°C for 3 hours. Then, an infrared absorption spectrum was measured to confirm the disappearance of absorption of isocyanate group, and the temperature inside the reaction container was cooled down to 70°C. Next, 2.25 g (11.0 mmol) of γ-isocyanatopropyl trimethoxysilane (product name: Y-5187 manufactured by Momentive Performance Materials LLC.) was added. The mixture was furthermore continuously stirred, and while maintaining the temperature inside the reaction container from 70 to 80°C, the reaction was continued for 3 hours. After that, an infrared absorption spectrum was measured to confirm the disappearance of absorption of isocyanate group, and the reaction was terminated to obtain urethane acrylate (hereinafter referred to as urethane acrylate F).

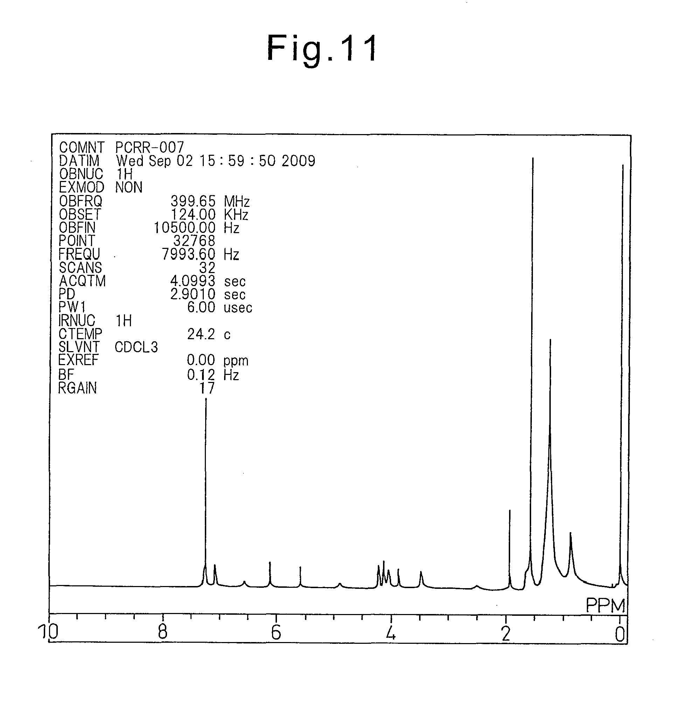

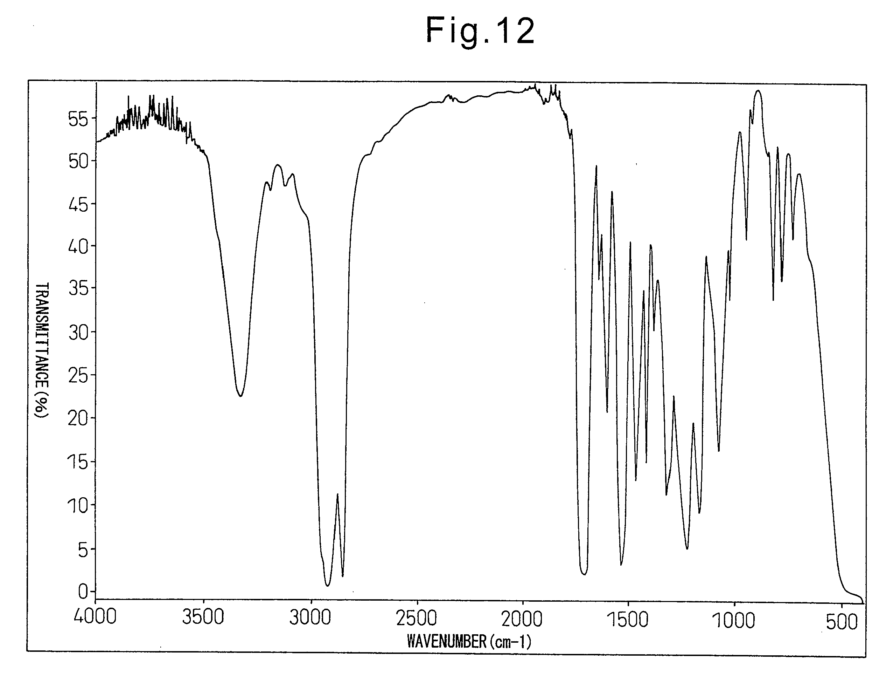

Figs. 11 and 12, respectively, show ¹H-NMR spectrum (solvent: CDCl₃) and IR spectrum, respectively, of urethane acrylate F.

### (Formulation Example 1)

Using a rotation/revolution mixer (product name: AWATORI RENTARO ARE-310 manufactured by Thinky Corp.), 55 g of the urethane acrylate A, 37 g of isobornyl acrylate (product name: IBXA manufactured by Osaka Organic Chemical Industry Ltd.), 5 g of 1,9-nonanediol diacrylate (NK ester A-NOD-N manufactured by Shin-Nakamura Chemical Co., Ltd.), 3 g of 3-methacryloyloxypropyl trimethoxysilane (KBM-503 manufactured by Shin-Etsu Chemical Co., Ltd.), and, as a photopolymerization initiator, 3 g of 2-hydroxy-2-methyl-1-phenyl-propan-1-one (product name: DAROCUR 1173 manufactured by Chiba Japan K.K.) were mixed together. Then, 0.5 g of an antifoaming agent (product name: TSA 750S manufactured by Momentive Performance Materials LLC.) was added and mixed together with a spatula. The mixture product was designated as curable composition A1. Curable composition A1 had a viscosity of 1670 mPa·s at 25°C.

### (Formulation Examples 2 to 7 and Comparative Formulation Example 1)

Using the same method as that of Formulation Example 1, the materials were mixed together according to compositions for formulation shown in Table 1. Mixture products prepared by Formulation Examples 2 to 5, respectively, were designated as curable compositions A2 to A7, respectively, and a mixture product prepared by Comparative Example 1 was designated as curable composition B1.

In the Formulation Examples and Comparative Formulation Example shown in Table 1, the amount of each component is in grams.

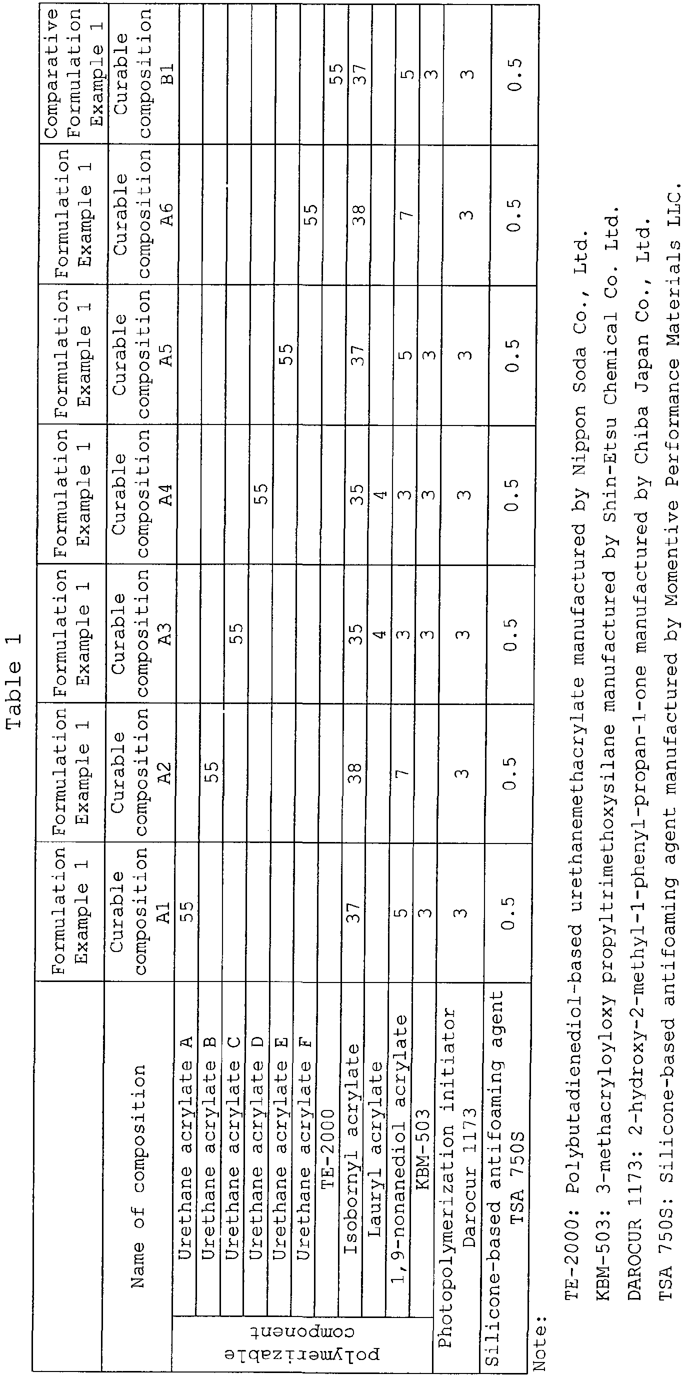

Additionally, the structural formula of TE-2000 used in Comparative Formulation Example 1 is shown as follows:

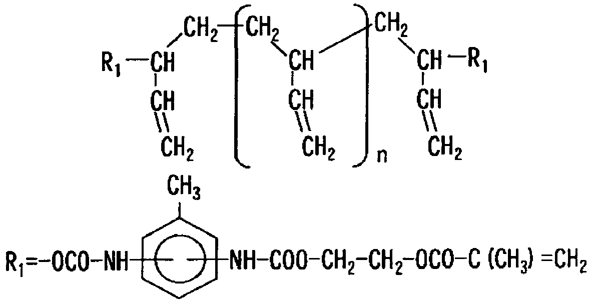

### <Evaluation of Curability>

Curable compositions A1 to A6 and B1 were applied to a glass plate (75 × 30 × 0.75 mm) in such a manner so as to have a film thickness of 100 µm and a width of 2.5 mm by an applicator. Then, using a conveyor-style UV irradiation apparatus (product name: GSN 2-40 manufactured by GS Yuasa Lighting Ltd.) with a high-pressure mercury vapor lamp, UV irradiation was carried out to cure the compositions under the condition: irradiation dose: approximately 1500 mJ/cm² (value at 365 nm), whereby a cured film for evaluation test was obtained, which was adhered to the glass plate and had a thickness of approximately 100 µm.

Regarding the cured film for evaluation test prepared with the thickness of approximately 100 µm, which was adhered to the glass plate, surface tack (surface curability) of the film was measured by finger contact. Table 1 shows the results. In Table 1, in the item of "curability", the mark O indicates that there is no or little surface tack; Δ indicates surface tack at a moderate level; and × indicates significant surface tack.

### <Evaluation of Adhesion to Glass and Detachability>

Only one end of the cured film for evaluation test was detached to obtain a test piece for adhesion measurement having a width of 2.5 mm. The adhesion was obtained by fixing the cured film to a tensile tester (EZ Test/CE manufactured by Shimadzu Corp.) in such a manner that the detached cured film forms an angle of 90 degrees with respect to the glass plate to measure a 90 degree-detachment strength at 23°C and at a speed of 50 mm/min. Table 2 shows the results.

In addition, the mark × in "detachability" means that the cured film was broken during the measurement of the 90 degree-detachment strength, whereas the mark O in "detachability" means that the cured film was able to be detached without breaking during the measurement thereof.

### <Evaluation of Long-term Electrical Insulation Reliability>

On a flexible wiring board prepared by performing tin plating on a substrate with a minute comb-shaped pattern (copper wiring width/width between copper wirings = 15 µm/15 µm) described in JPCA-ET01, which was produced by etching a flexible copper clad laminate (grade name: ESPERFLEX; copper thickness: 8 µm and polyimide thickness: 38 µm, manufactured by Sumitomo Metal Mining Co., Ltd.), curable composition A1 was applied by an applicator in such a manner that a thickness of the composition from a polyimide surface was 150 µm. Using the conveyor-style UV irradiation apparatus (product name: GSN 2-40 manufactured by GS Yuasa Lighting Ltd.) with the high-pressure mercury vapor lamp, curable composition A1 was irradiated with light at an exposure dose of 600 mJ/cm² (value at 365 nm) under a nitrogen atmosphere to cure curable composition A1, whereby there was obtained a test piece coated with a cured product obtained by curing curable composition A1.

Using the test piece, a temperature/humidity steady state test was conducted by application of a bias voltage of 60V under the conditions: temperature 85°C and humidity 85% RH, using MIGRATION TESTER MODEL MIG-8600 manufactured by IMV Corp. Table 2 shows resistance values at an initial period from the start of the temperature/humidity steady state test, 1 hour later than the start thereof, 250 hours after that, and 500 hours after that, respectively.

Additionally, the same evaluation was conducted using curable compositions A2 to A5 and curable composition B1. The results of the evaluation are also shown in Table 2.

**Table 2**

| Name of composition | | Curable composition A1 | Curable composition A2 | Curable composition A3 | Curable composition A4 | Curable composition A5 | Curable composition A6 | Curable composition B1 |
|---|---|---|---|---|---|---|---|---|
| Viscosity at 25°C (mPa·s) | | 1670 | 1720 | 1500 | 1610 | 1500 | 1330 | 2020 |
| Curability | | ○ | ○ | ○ | ○ | ○ | ○ | ○ |
| Adhesion to glass(N/cm) | | 5.0 | 5.5 | 4.0 | 4.1 | 3.3 | 4.6 | 0.7 |
| Detachability from glass | | ○ | ○ | ○ | ○ | ○ | ○ | ○ |
| Long-term insulation reliability (Ω) | 1 hour later | 2.38 × 10¹¹ | 2.98 × 10¹¹ | 2.36 × 10¹¹ | 2.33 × 10¹¹ | 5.08 × 10¹¹ | 1.87 × 10¹¹ | 2.37 × 10¹¹ |
| | 250 hours later | 9.96 × 10¹¹ | 1.28 × 10¹² | 9.98 × 10¹¹ | 9.97 × 10¹¹ | 2.30 × 10¹² | 1.51 × 10¹² | 6.25 × 10¹² |
| | 500 hours later | 1.23 × 10¹² | 1.96 × 10¹² | 1.27 × 10¹² | 1.26 × 10¹² | 3.10 × 10¹² | 2.49 × 10¹² | 7.35 × 10¹² |

The results of Table 2 show that the compound of present invention (I) and/or the compound of present invention (II) can reduce the viscosity of the curable composition after mixed, as compared to existing urethane (meth)acrylate compounds, and a cured film obtained by curing the curable composition has excellent adhesion to glass and excellent detachability, as well as the photocurable moisture-proof insulating coating material for mounting circuit boards according to the present invention exhibits long-term high level electrical insulating properties.

### INDUSTRIAL APPLICABILITY

As described hereinabove, the curable composition comprising the compound of present invention (I) and/or the compound of present invention (II) can provide a photocurable moisture-proof insulating coating material for mounting circuit boards that has less environmental impact, low moisture permeability, and sufficient adhesion to substrate materials. Additionally, an electronic component insulated with the photocurable moisture-proof insulating coating material for mounting circuit boards is highly reliable and useful for mounting circuit boards where a microcomputer and other various components are mounted.

## Claims

1. A photocurable moisture-proof insulating coating material for mounting circuit boards, comprising a curable composition comprising:
(component A) a compound having a structural unit derived from a dimerdiol and having, as an end group, a group represented by formula (1): 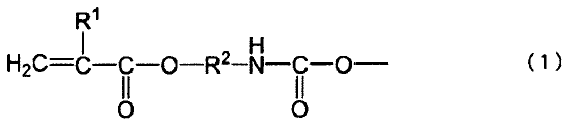 wherein R¹ represents H or CH₃ and R² represents a hydrocarbon group having 2 to 12 carbon atoms, at an end of the compound;
(component B) a non-silicon-containing monofunctional (meth)acryloyl group-containing compound; and
(component C) a photopolymerization initiator.

2. An electronic component insulated with the photocurable moisture-proof insulating coating material for mounting circuit boards according to claim 1.
